(19) **Europäisches Patentamt**
**European Patent Office**
**Office européen des brevets**

(11) **EP 0 528 634 B1**

(12) **EUROPEAN PATENT SPECIFICATION**

(45) Date of publication and mention
of the grant of the patent:
**23.12.1998 Bulletin 1998/52**

(51) Int Cl.⁶: **G01R 21/133**, H02J 13/00,
H01H 73/00

(21) Application number: **92307394.4**

(22) Date of filing: **12.08.1992**

(54) **Energy monitoring system for a plurality of local stations with snapshot polling from a central station**

Leistungsüberwachungssystem für eine Mehrzahl lokaler Unterstationen mit einer
Rundum-Augenblickswertabfrage von einer Zentralstation aus

Système de surveillance d'énergie pour une pluralité de stations locales avec interrogations sélectives
de valeurs instantanées à partir d'une station centrale

(84) Designated Contracting States:
**DE ES FR GB IT SE**

(30) Priority: **15.08.1991 US 746018**
**15.08.1991 US 746019**

(43) Date of publication of application:
**24.02.1993 Bulletin 1993/08**

(73) Proprietor: **EATON CORPORATION**
**Cleveland, Ohio 44114-2584 (US)**

(72) Inventors:
• **Oravetz, David Michael**
**Gibsonia, PA 15044 (US)**
• **Elms, Robert Tracy**
**Monroeville, PA 15146 (US)**
• **Engel, Joseph Charles**
**Monroeville, PA 15146 (US)**
• **Klancher, Frank**
**Pittsburgh, PA 15241 (US)**

• **Kinny, Thomas Joseph**
**Pittsburgh, PA 15239 (US)**
• **Peterson, Clyde Owen**
**Pittsburgh, PA 15239 (US)**
• **Mueller, Dennis Armin**
**Asheville, NC 28803 (US)**
• **Bell, Richard Burns**
**Pittsburgh, PA 15241 (US)**
• **Cather, Robert Lee**
**Turtle Creek, PA 15145 (US)**

(74) Representative: **van Berlyn, Ronald Gilbert**
**23, Centre Heights**
**London NW3 6JG (GB)**

(56) References cited:
**EP-A- 0 432 367        GB-A- 2 219 448**
**US-A- 4 164 719        US-A- 4 308 511**
**US-A- 4 783 748        US-A- 4 803 632**
**US-A- 4 819 180**

## Description

This invention relates to load management for electrically operated loads, and in particular to a PC computer monitored system for instantaneously ascertaining the individual consumption of energy by users at several locations behind the meter which has been installed by the electrical utility company for computing the total energy used from the main lines.

The electrical companies usually place at least one meter at the junction of the main distribution power lines with their customer consumption location, that it be a factory, a house, a shop, a business, or a residential building, thereby to collectively monitor the kilowatts drawn from the main AC lines on the basis of the sensed voltage and current, and to compute the energy so as to bill the customer according to actual demand. It is now proposed to determine at the customer's level how much at a sublevel has been consumed, behind such an electrical meter of the utility company, at each of the sublocations of users in order that the billing can be divided and the cost fairly distributed between them, that they be residents, tenants, workshop craftsmen, or shopkeepers.

The specification of U.S. Patent No. 4,168,491 shows the control of the demand of energy consumed by several users pertaining to a common building. The purpose, there, is to stop the user's consumption whenever it exceeds a predetermined limit. To this effect, when power may be exceeded, from a central location all the users in the group are distributively switched OFF, either cyclically and for a certain duration, or told to switch OFF.

It is known from the specification of U.S. Patent No. 3,937,978 to control remotely electrical loads, such as multi-unit lodging establishments, power sensing being used to deenergize a load having excessive consumption.

From the specification of U.S. Patent No. 3,906,242 it is known to monitor loads under programmed peak load reduction from a computer load center operating with a signal transmitter upon a plurality of installations having their local signal receiver and load limiter.

The specification of U.S. Patent No. 4,090,062 shows an energy demand controller for a house, or a building, having separated heaters and appliances, each having a local control unit and an intermediary switch.

In the specification of U.S. Patent No. 4,100,426 load controlling is accomplished with plug-in modules which are part of a standard package associated with the respective loads for a given installation.

The specification of U.S. Patent No. 4,206,443 discloses protective load disconnection is remotely performed at a single control input terminal from a master controller and monitoring unit.

The specification of U.S. Patent No. 4,874,926 discloses the use of low voltage thermal relays placed adjacent to the downstream or outlet side of a residential circuit breaker in the in-residence power distribution lines leading to individual electrical heating elements.

The specification of U.S. Patent No. 4,164,719 is for a load management application wherein, between the local load and the power input, a conventional circuit breaker is combined with a management module.

The specification of U.S. Patent No 4,178,572 is provided with a contactor-circuit breaker arranged for mounting in the same panelboard having the load circuit breaker serving for energization.

The specification of U.S. Patent No. 4,308,511 relates to a load management circuit breaker containing an electronic package and a remote-controlled switch, associated with an electric energy meter and a master control transmitter connected through a line of communication.

The specification of U.S. Patent No. 4,806,855 relates to a system for rating electric power transmission lines. The system there described includes current sensor-transmitter for multiplexed transmission by telecommunication-link to a computer.

The specification of U.S. Patent No. 4,219,860 shows digital overcurrent relay apparatus using sampling with digital conversion in relation to the monitored AC current.

In the specification of U.S. Patent No. 4,423,459 a solid state circuit is illustrated involving AC current monitoring by sampling and digital conversion.

In the specification of U.S. Patent No. 4,682,264 a microprocessor-based solid-state trip unit processes digital signals derived from current sensors.

In the specification of U.S. Patent No. 4,783,748 a method and apparatus are disclosed for sensing, sampling and performing calculations on a parameter of a physical quantity at a plurality of remote locations comprising a plurality of remote sensing units and at least one processing unit linked to said plurality of remote sensing units via a two way communication link. Parameters of a physical quantity are sensed and sampled, calculations are performed and accumulated and transmitted, on demand, provided to the processing unit using a plurality of frequency bands one of which is identified as having valid data.

According to one aspect of the invention there is provided an electrical monitoring system for use on an AC line, comprising a circuit breaker installed on said AC line, characterised in that a backpack unit is mounted on said circuit breaker and has an opening through which said AC line is passed, said backpack unit further has mounted therein transducer means cooperating with said AC line for deriving analog signals representative of AC line current and voltage, analog to digital means for converting said analog signals to digital signals, and processing means for computing electrical measurements from said digital signals;

a remote monitoring device for retrieving said computed electrical measurements; and

bi-directional digital communication means linking said backpack unit and said remote monitoring device for establishing a data highway therebetween.

Preferably, the transducer means comprises a current transducer inductively coupled with the AC line and a voltage metering device connected to the AC line.

The monitoring system of the invention may further include a PC board mounted in the backpack unit having an opening around which is mounted the current transducer and wherein said AC line is passed through said opening and through said current transducer.

Preferably the analog to digital means and the processing means are integrated in a CMOS monolithic circuit.

The monitoring system of the invention may further include a second PC board mounted in the backpack unit on which the CMOS monolithic circuit is mounted.

According to another aspect of the invention there is provided an electical monitoring system for use behind a collective electrical meter having a plurality of AC lines associated therewith, said system comprising a plurality of circuit breakers wherein each one of said AC lines has installed thereon one of said plurality of circuit breakers, characterised in that a plurality of backpack units is individually mounted on each of said circuit breakers, each of said backpack units having an opening through which said AC line passes so that a backpack unit mounts to a circuit breaker and an AC line passes through the backpack unit and connects to the circuit breaker, and in that each of said backpack units further has transducer means cooperating with said AC line for deriving analog signals representative of AC line current and voltage, analog to digital means for converting said analog signals to digital signals, processing means for computing electrical measurements from said digital signals and storage means for saving said electrical measurements;

a remote monitoring device for retrieving said electrical measurements from each of said plurality of backpack units; and

bi-directional digital communication means linking said remote monitoring device to each of said plurality of backpack units for establishing a data highway therebetween.

Preferably the bi-directional communication system is used at regular successive intervals by the remote monitoring device to initially and simultaneously address and command each of the plurality of backpack units to store the electrical measurements whereby said remote monitoring device may address and poll each of the plurality of backpack units individually to retrieve the stored electrical measurements.

Preferably, the transducer means comprises a current transducer inductively coupled with the AC line and a voltage metering device connected to the AC line.

It is further preferred that each of the plurality of backpack units further has a PC board mounted therein having an opening around which is mounted the current transducer and wherein the AC line passes through said opening and through said current transducer.

The analog to digital means and the processing means may be integrated in a CMOS monolithic circuit.

Preferably, each of the plurality of backpack units further has a second board on which thc CMOS monolithic circuit is mounted.

The digital data-link used in the preferred embodiment is of the type disclosed in the specification of U.S. Patent Nos. 4,563,073; 4,644,547, and 4,866,714.

The invention is applicable to mere performing of metering functions at the level of the several local users with centralized monitoring and accounting of the individual demand and energy billings. It is also applicable to individual billing of the electrical utility share under the company billing system which may include peak-demand ratings, for instance.

The invention will now be described, by way of example, with reference to the accompanying drawings in which:-

Figure 1 is a schematic diagram of a panelboard installation incorporating the energy monitoring system according to the invention coupled, through individual backpack units, to a plurality circuit breakers serving local users;

Figures 2A and 2B are front and top views of one of the circuit breakers of Figure 1;

Figures 3A, 3B and 3C are front, top and side views of one of the backpack units of Figure 1, whereas Figure 3D is like Figure 3B, but with a circuit breaker shown coupled to it;

Figures 4A and 4B are front and top views of one of the circuit breakers of Figure 1, the two opposite conductor terminals being shown in Figure 4A attached to the respective incoming and outgoing cable lines, the associated backpack unit being shown plugged-in on the outgoing local load line side;

Figure 5A is, like Figure 3A, a front view of one of the backpack units of Figure 1, with Figures 5B and 5C showing two cross-sections of the backpack unit of Figure 5A;

Figure 6A is a front view of the lug of the backpack unit of Figures 3A, 3B, 3C, 5A, 5B or 5C, as it is mounted near the rim of the printed-circuit board opening through which a cable line is to be axially passed; Figure 6B is a cross-section taken from Figure 6A;

Figure 7 shows side-by-side the two printed-circuit boards of Figure 1;

Figures 8A and 8B are illustrating the internal organization of a backpack unit built around two printed-circuit boards, the latter being initially mounted side-by-side (Figure 8A) before being folded and brought on top of the other (Figure 8B) once assembled;

Figure 9 is an exploded view of the bottom casing of the backpack unit and its cover, the functional unit of Figure 8B being shown nearly sandwiched therebetween;

Figures 10A and 10B are separate views, taken in perspective, of the bottom casing and the cover used for the backpack unit of Figure 9;

Figure 11 shows diagrammatically the mechanical and electrical connections within the backpack unit;

Figure 12 illustrates the energy monitoring system according to the invention with a PC computer operator control station, connected to a plurality of slave backpack units, each backpack unit being coupled, or to be coupled, to a corresponding circuit breaker serving the local electricity user, monitoring being effected through a common line of communication, with an optional local data collecting station inserted therein;

Figure 13 illustrates in an exploded view the face-to-face relationship between the two printed-circuit boards which inside the backpack unit establish an interface between the circuit breaker terminal sensing functions and the lower-link functions of the PC computer communication line;

Figure 14 is a diagram illustrating the current and voltage sensing functions involved in the transducer printed-circuit board;

Figure 14A shows the internal circuitry of the printed-circuit board of Figure 14;

Figure 15 is a schematic representation of the basic functions performed digitally by the printed-circuit board interfacing with an INCOM communication line to the PC computer;

Figure 16 is an overall view of the energy monitoring system according to the present invention;

Figure 16A shows the backpack unit according to the present invention mounted in an expanded mode slave relationship with the INCOM communication line to the PC computer;

Figure 17 is a diagram illustrating the INCOM communication line connection with the digital printed circuit board of a backpack unit through a Sure Plus Chip;

Figure 18A is a diagram showing the interface between the INCOM communication line and the Sure Plus Chip of Figure 17;

Figure 18B illustrates circuitry used in the implementation of the diagram of Figure 18A;

Figures 19A-19C illustrate the overall circuitry of the digital printed-circuit of the backpack unit according to the present invention;

Figure 19D shows the connector associated in the circuitry of Figures 19A-19C with the signals received from the current and voltage printed-circuit board;

Figure 19E is illustrative of circuitry involved for the power supply in the board of Figures 19A-19C;

Figure 20 illustrates the angular distribution about a circle of the 8 samples of the first octave under the sampling process according to the preferred embodiment of the invention;

Figure 21A illustrates on a half-cycle, the distribution of two consecutive octaves of samples, whereas Figure 21 B is the corresponding half-cycle of the fundamental waveform;

Figure 22A is a diagram showing the interface between the inputted signals with the chip SP; Figures 22B and 22C show the voltage and the current mode of chip operation in the A/D conversion process, with Figures 22D and 22E being their equivalent circuits, respectively; Figure 22F shows circuitry of the chip SP performing a change from voltage to current mode depending upon the input signals; and Figure 22G gives the reference to a fundamental cycle for the two afore-stated modes;

Figure 23 is a diagram illustrating the circuitry involved in the chip SP of Figure 19 for the current and voltage modes of Figures 22B and 22C;

Figures 24A, 24B and 24C are flowcharts illustrating the operation of the energy monitoring system when at the user's station sampling current and voltage, calculating energy and accumulating an instantaneous total of energy according to the present invention;

Figure 25 is a block diagram illustrating snapshot operation from the PC computer station of the energy monitoring system according to the invention;

Figure 26 is a general block diagram of the energy monitoring system;

Figures 27A, 27B, and 27C are flowcharts explaining the operation of the energy monitoring system of Figures 25 and 26.

Figures 28A, 28B, 28C, 28D and 28E are flowcharts illustrating the operation of the energy monitoring system at the user's station sampling current and voltage, calculating energy, RMS current and voltage, average power, apparent power, reactive power, and the power factor; and Figure 29 is a block diagram illustrating the operation of the computer station acting in conjunction with the energy monitoring system.

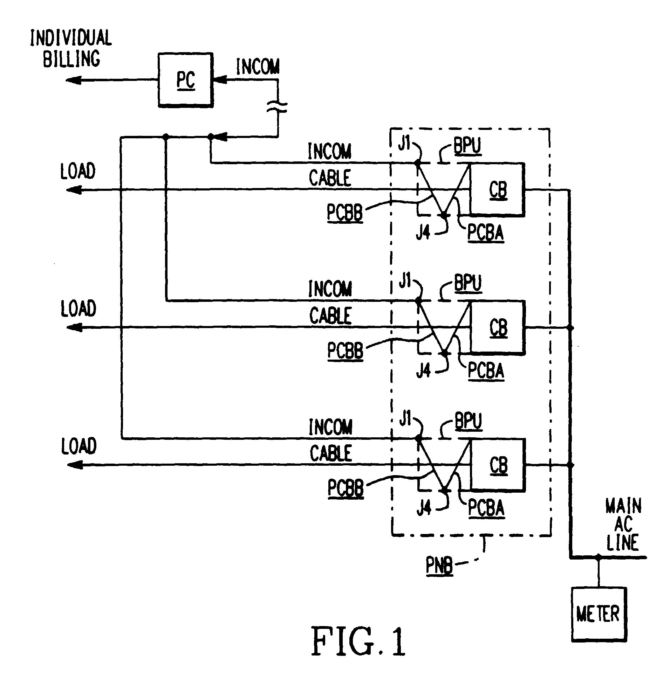

Figure 1 shows a diagrammatical view of the energy monitoring system embodying, several backpack units BPU each coupled with one of several circuit breakers CB which are part of a panel board PNB through which the main electrical AC lines are interconnected with local cables leading individually to serve separate user's loads. Each backpack unit includes two printed-circuit boards PCBA and PCBB which are interconnected at J4, one (PCBA) for effecting current transducer and voltage sensing functions with the circuit breaker, the other (PCBB) for deriving digital information therefrom (at junction J1) which is transmitted through a telecommunication channel INCOM for bilateral transmission with a PC computer PC. As a result of energy monitoring through a selective combination of the several printed-circuit boards with the PC computer, it is possible from the PC computer station to establish instantaneously individual load billings for the different local users, at a stage which is after the collective Meter (Figure 1) installed by an electrical system supplying energy through the main AC lines.

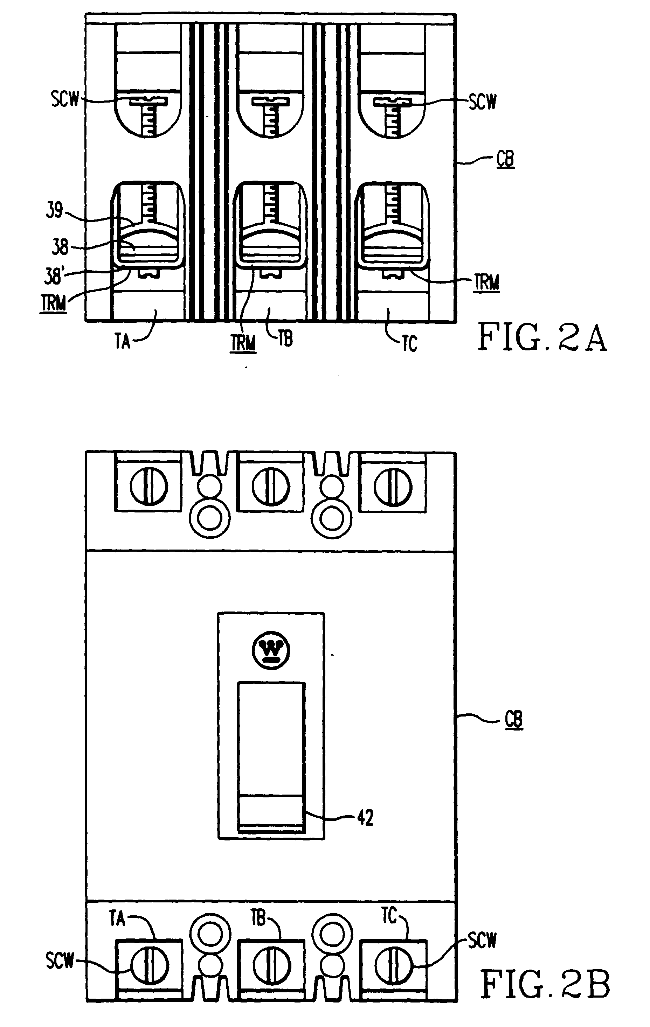

Figures 2A and 2B are front and top views, respectively, of a circuit breaker which can be installed, as illustrated by CB in Figure 1. The circuit breaker, typically has three female terminals TA, TB and TC (for the respective poles, in a three-pole example) upon which the individual local cables (each shown as only one pole in Figure 1) are attached between a screw (SCW) driven member 39 engaging the cable and a stopping member 38 held by a bracket 38' within the terminal (TA, TB, or TC). The handle is protruding at 42, for manual control, namely, on the front plane of the panel board PNB of Figure 1. Figures 2A and 2B are taken from the specification of U.S. Patent No. 3,892,298. As shown in Figure 1, the local cable, before entering with its open end the terminal of the circuit breaker, is passed through the two printed circuit boards PCBA and PCBB, which have been provided, each with a proper opening (not shown). The other side of the circuit breaker is likewise connected through terminals to the AC lines from the Electrical Company.

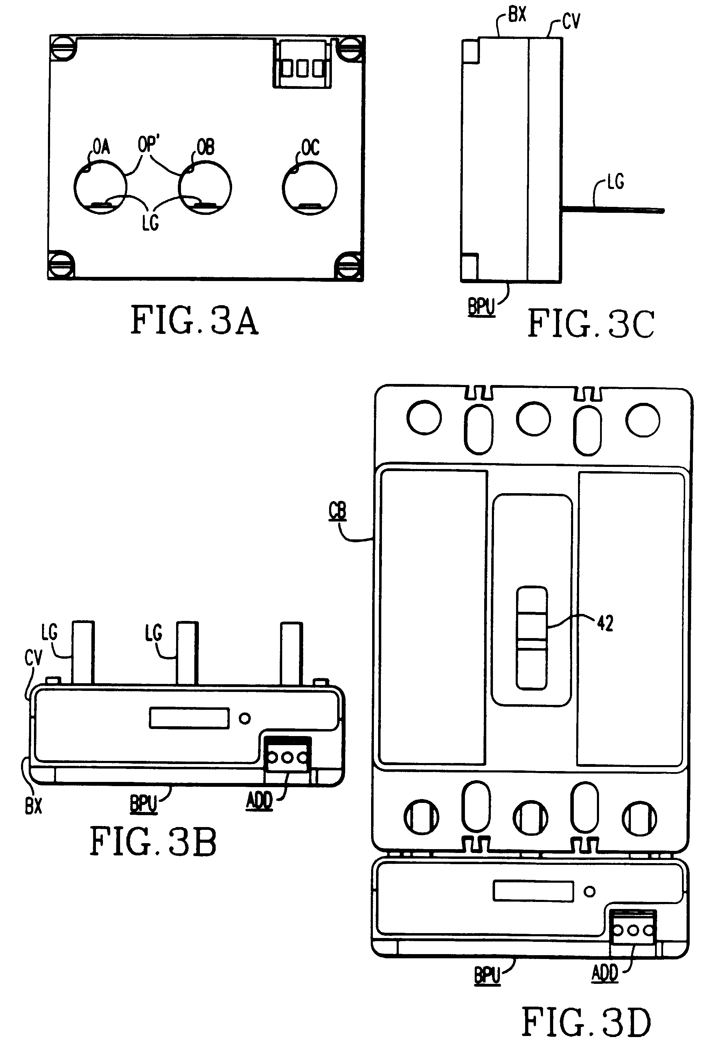

Figures 3A, 3B and 3C are front, top and side views of one of the backpack units BPU of Figure 1, shown as a housing comprising a bottom casing BX and a cover CV, with protruding blades, or lugs, LIG, one for each pole of a three-pole circuit breaker such as the one of Figures 2A and 2B. J1 is the connector, inserted within the BPU housing, into which the telecommunication line INCOM of Figure 1 is plugged-in. Three circular openings (OA, OB, OC) are visible (on Figure 3A) which are provided crosswise through the entire housing and the internal printed-circuit board assembly (PCBA and PCBB on Figure 1) of the backpack unit BPU. A lug or stab LG is seen mounted in each hole (OA, OB, OC). The local user's cable associated with one pole of the circuit breaker is passed through a corresponding opening (OA, OB, or OC) of the circuit breaker housing, and beyond it, its open end is placed along the lug LG, or conversely, within the terminal (TA, TB, or TB in Figure 2A) of the circuit breaker, so that cable conductor and lug become held together, while being closely pressed under the tight grip of a screw for good electrical contact. Figure 3D shows the backpack unit BPU plugged-in with the circuit breaker CB.

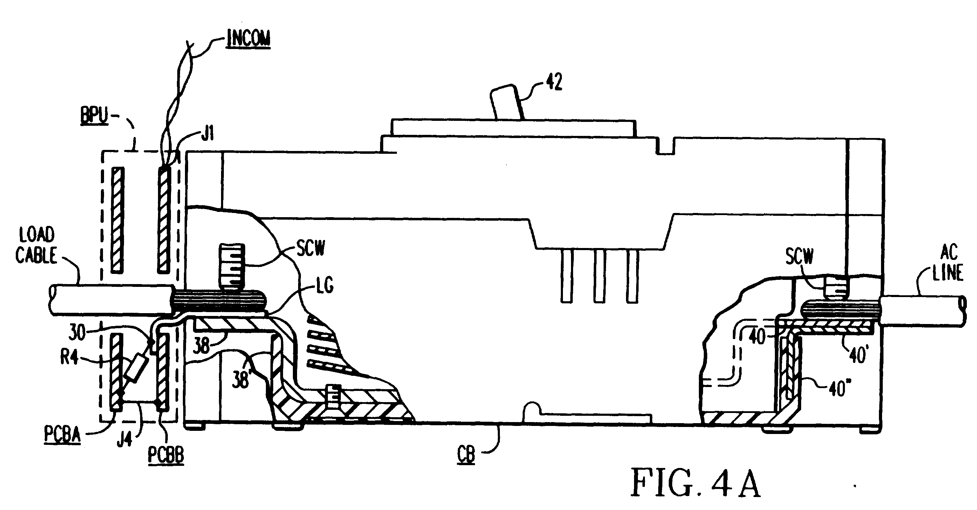

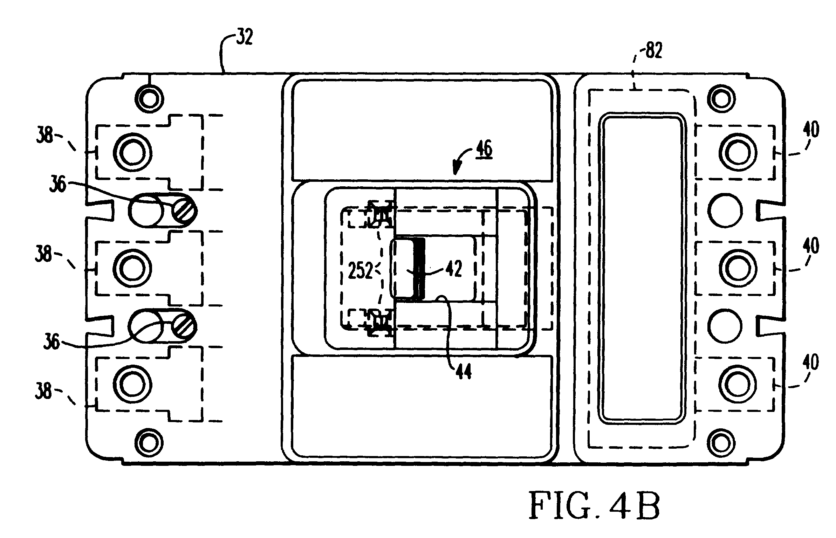

Figure 4A is a side view of the circuit breaker of Figure 3D (while Figure 4B is a top view thereof) showing the naked end of the electrical cable from the local user engaged with the terminal conductor 38 of the breaker and pressed against it under a screw SCW. The local user's cable passes across the housing of the backpack unit BPU and through two parallel printed-circuit boards PCBA and PCBB. Although in Figure 1, printed circuit PCBA is shown closer to the circuit breaker CB whereas the other printed-circuit PCBB appears on the opposite side and closer to the communication line INCOM, in Figure 4A the PCBB printed-circuit board is shown mounted close to the circuit breaker, a lug LG being attached to it and extending therefrom directly to the outside for insertion into the terminal (TA, TB or TC of Figure 2A). Consequently, from a rivet of fixation 30, mounted on printed-circuit board PCBB, is derived a signal characteristic of the phase voltage which is passed to the other printed-circuit board (PCBA), via a resistor R4 (for phase A, for instance). As will be explained in detail hereinafter, printed-circuit board PCBA supports transducers which sense the phase currents passing through the local cable. Therefore, the sensed phase voltage signal passed through R4 is also received by board PCBA. Conversely, via an electrical connector J4, the current and voltage sensed signals are together passed to the PCBB printed-circuit. There, after digital conversion and digital treatment, there will be information passed, through connector J1 of printed-circuit board PCBB, to the INCOM line leading to a PC computer for central monitoring of the energy consumed through the particular circuit breaker and the local user's cable. The circuit breaker's conductor 38 is mounted on a bracket 38'. The terminal bare end of the cable is pressed with a screw against the lug LG of the backpack unit, the latter being squeezed between the cable and conductor 38. The AC line is fixed inside the opposite terminal of the circuit breaker directly against conductor 40, the latter being mounted on a bracket 40', as generally known.

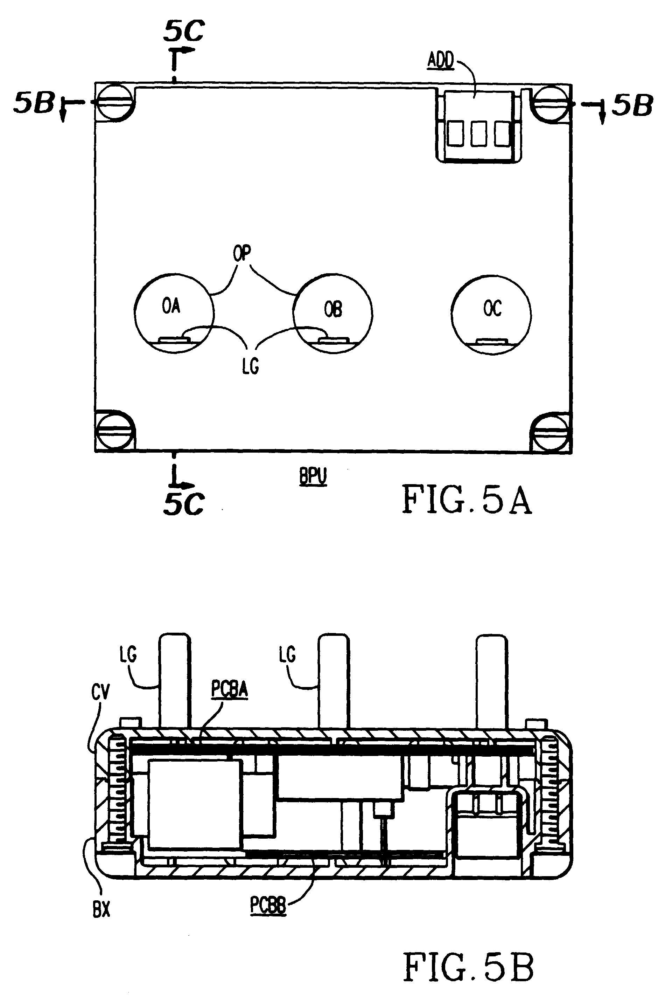

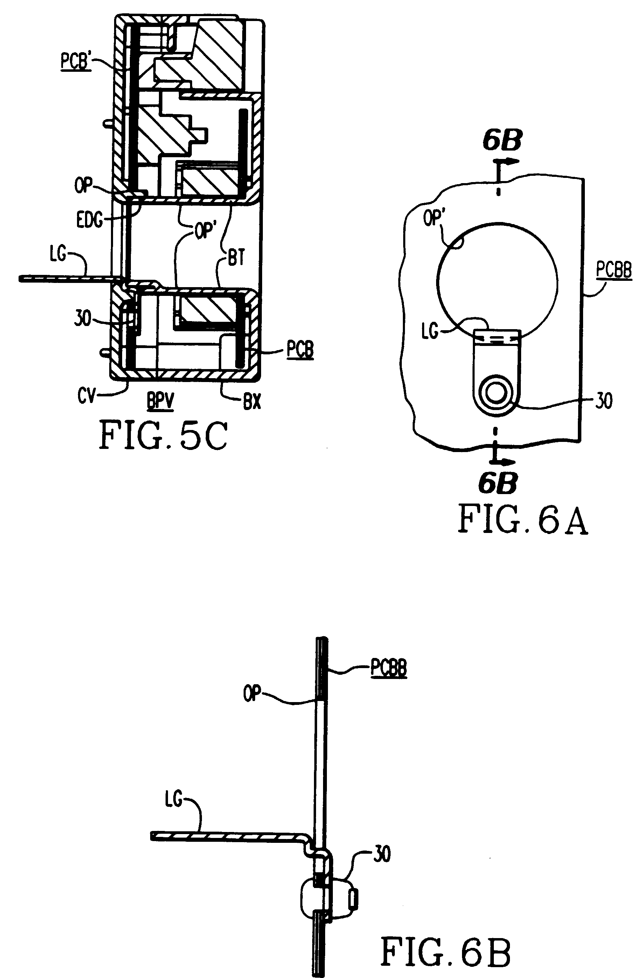

Figure 5A is a front view of a backpack unit, like in Figure 3A, bearing cross-section lines F-F and A-A to which are related the cross-sectional views of Figures 5B and 5C, respectively. Figure 5C shows lug LG as installed and mounted with its rivet 30. The parallel printed-circuit boards have a circular opening (OA for phase A, for instance) having a rim OP. The insulating housing includes a bottom casing BX having a plastic boot BT, extending across the openings of the two printed-circuit boards (PCBA and PCBB), with an internal cylindrical surface OP' of sufficient diameter to allow the local cable therethrough. Boot BT, extends in proximity of the rim OP of the printed-circuit boards. It starts from the bottom of casing BX until it engages at the other end a complementary circular ridge EDG provided on the bottom of the cover CV. The two are joined together to close the space and provide insulation in the gap between rim OP of the printed-circuit boards and the axially mounted local cable.

Figures 6A and 6B show lug LG as it is mounted on the printed-circuit board PCBB. Figure 6B is a cross-section along line BB of Figure 6A. OP is the rim of the opening OA (for phase A, instance).

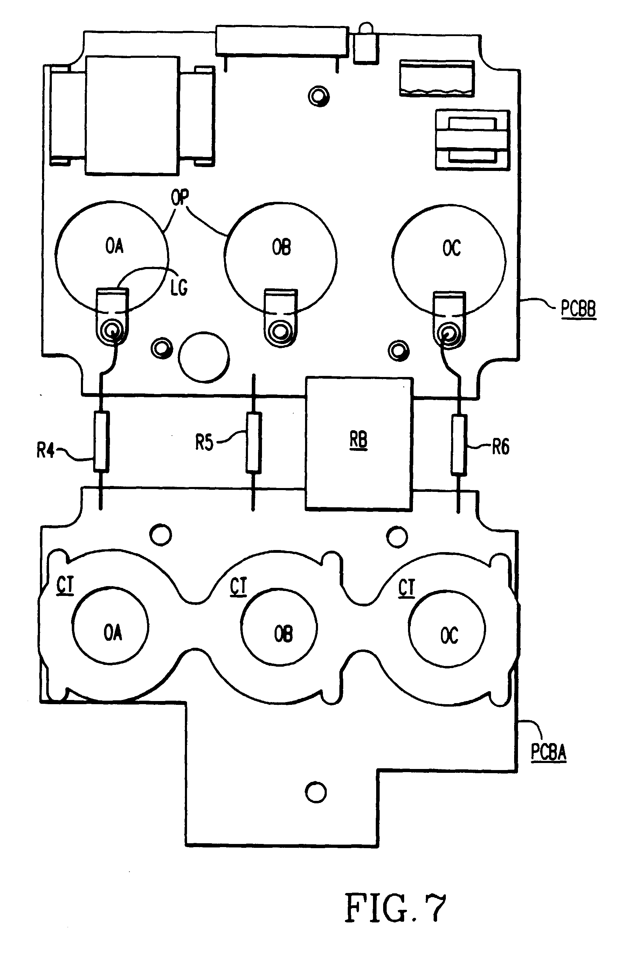

Figure 7 illustrates how the two printed-circuit boards are connected side-by-side. Each lug (one for each of the respective openings OA, OB, OC in the case of a three-pole circuit breaker) LG is mounted on board PCBB with a rivet 30 which is electrically connected by line 10 to a resistor R4 (for opening OA and phase A), R5 (for OB), or R6 (for OC) which are bridging the two edges of the two printed-circuits boards. Printed-circuit PCBA shows circular compartments CT for the current transducers of opening OA, OB and OC, destined to surround the local cable for sensing. The AC voltage representative signals VA, VB, VC (derived through resistors R4, R5 and R6), and the current representative signals IA, IB, IC (derived from the current sensors CT) are, via connecting lines (assembled at J4 in Figure 4A), passed back through a ribbon RB to the PCBB printed-circuit board for digital treatment thereon.

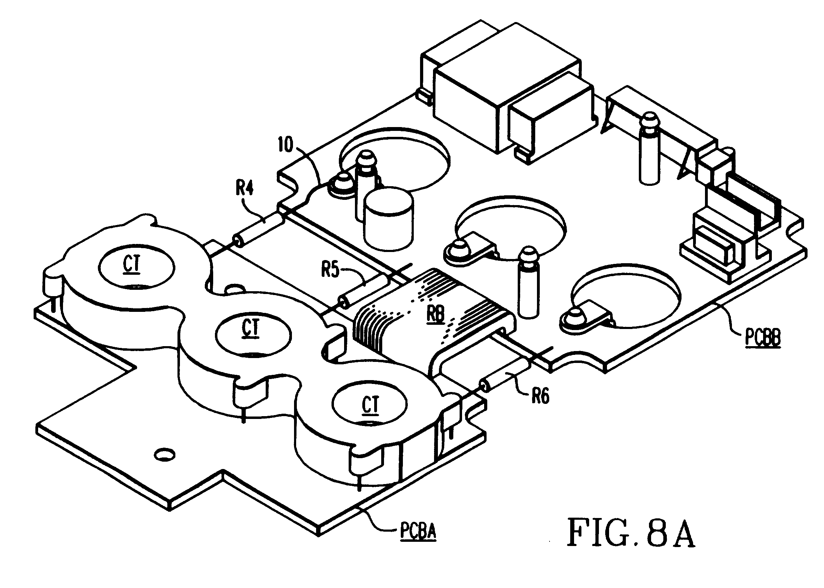

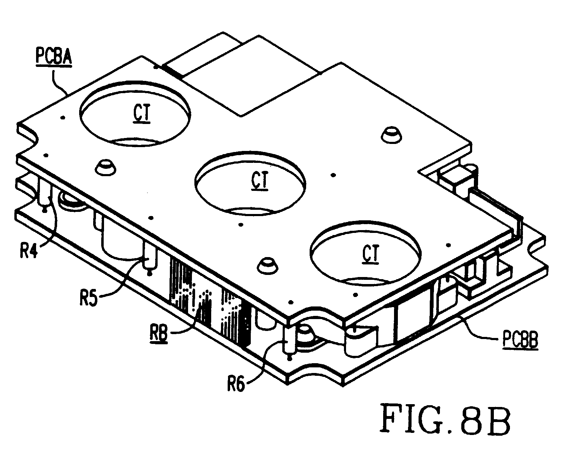

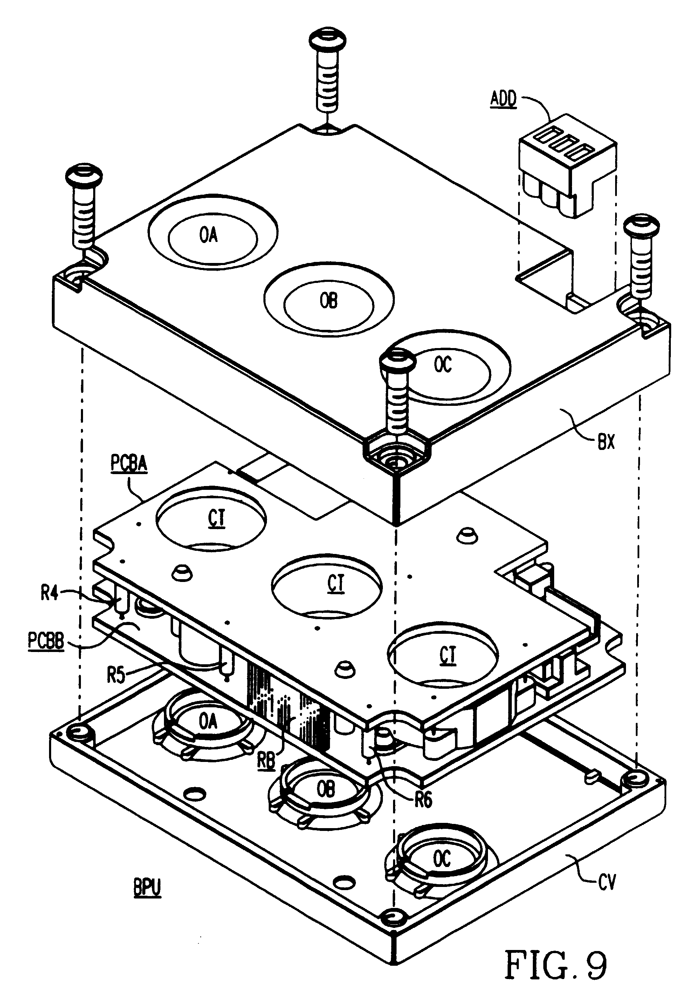

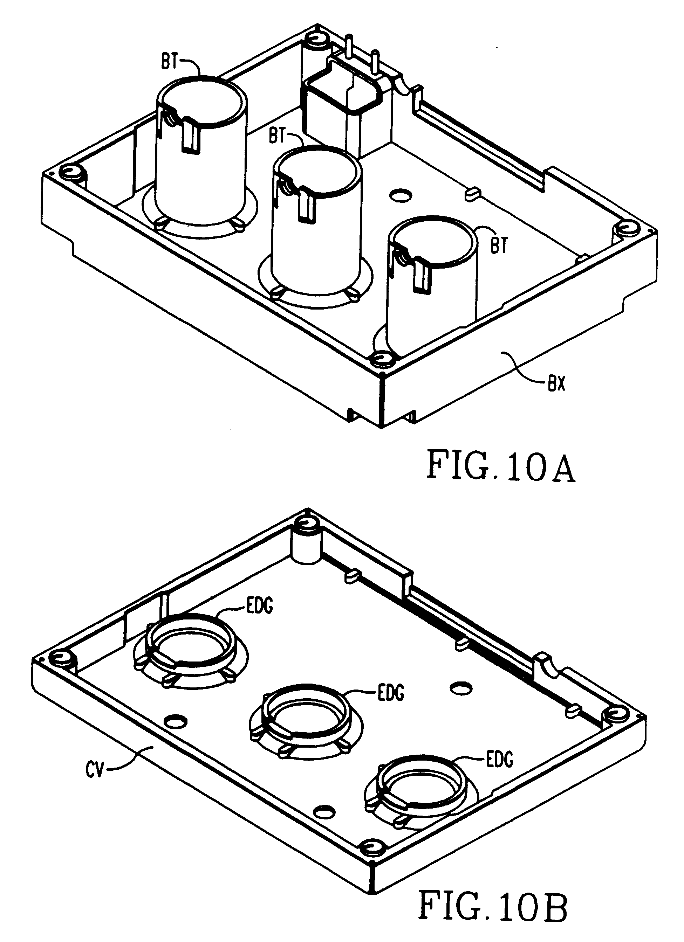

Figures 8A and 8B are perspective views of the two printed-circuit boards of Figure 7 shown after they have been fully mounted with additional equipment, such as transformers, connectors, pins and fixation tools. One view (Figure 8A) shows the two boards side-by-side, the other (Figure 8B) shows them together after board PCBA has been folded on top of board PCBA. Figure 9 is an exploded view of bottom casing BX and of cover CV of a backpack unit BPU, the two printed-circuit boards of Figure 8B being shown sandwiched therebetween. Figure 10A is a perspective view of the bottom casing BX with the three boots BT to be inserted through the respective printed-circuit board openings. Figure 10B is a perspective view of the cover CV with its three edges EDG. They both have plastic rectangular bodies provided at the four corners with matching holes to allow rods having threaded ends to be passed therethrough when closing the overall housing of the backpack unit with screws.

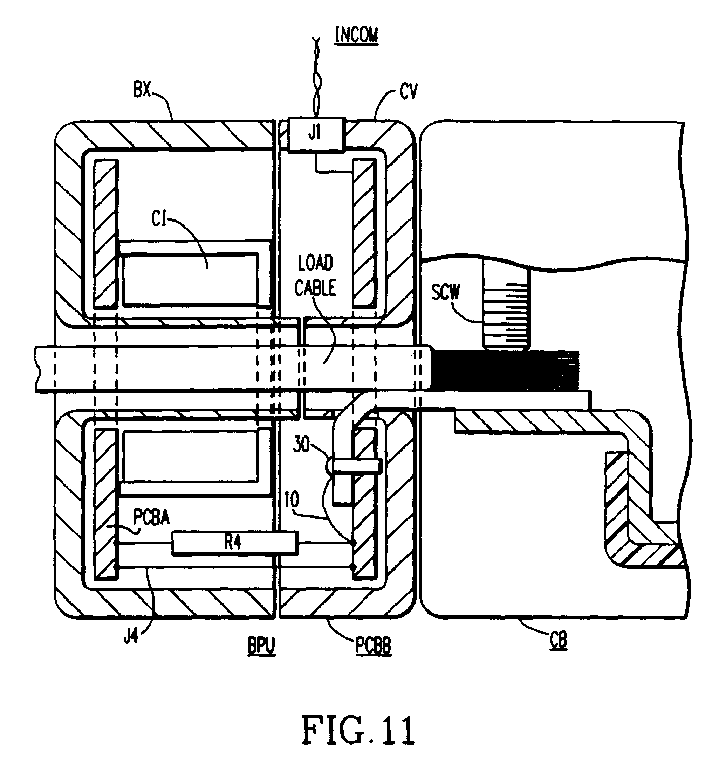

Figure 11 is a cross-section showing, with more details than with Figure 4A, how the internal parts are assembled between one terminal of the circuit breaker CB and the central opening of the backpack unit BPU. The transducer CT is shown in position within the corresponding compartment of the bottom casing BX of Figure 7. Connector J1 is interposed between the upper edge of the PCBB printed-circuit and the INCOM line. Connector J4 is between PCBA and PCBB, and so is resistor R4 connecting radial line 10 of PCBB to PCBA (for opening OA, for instance).

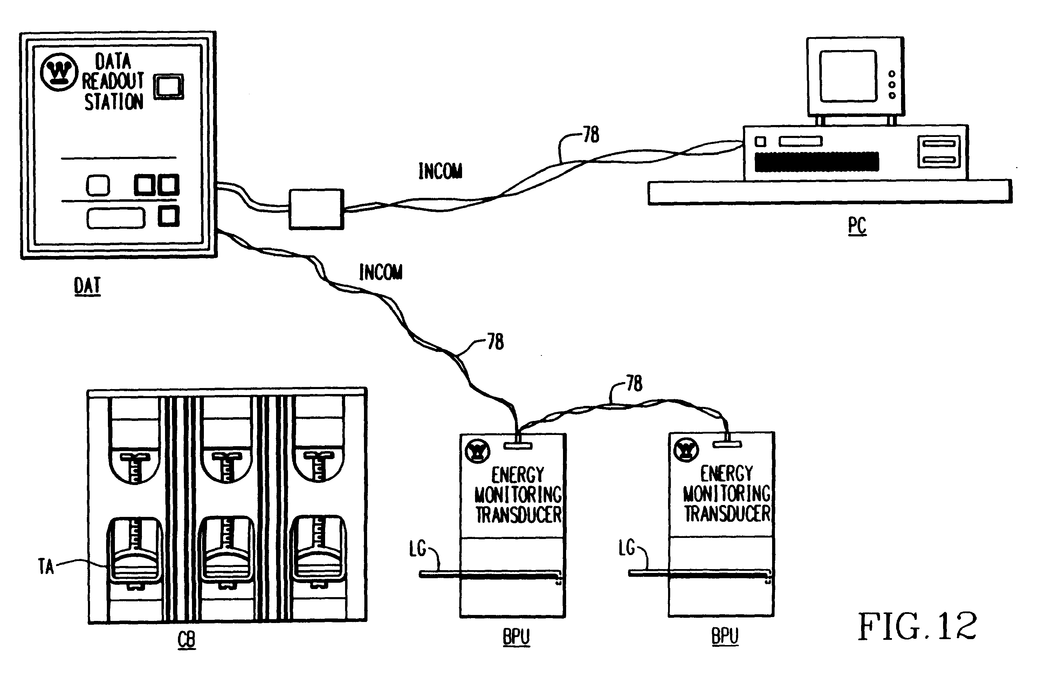

Figure 12 illustrates the backpack units according to the invention as occupying expanded-slave stations within an INCOM system like the one described in the specification of U.S. Patent No. 4,866,714. Two backpack units BPU are shown pertaining to two different circuit breakers (only one being shown at CB for the purpose of clarity). A two-wire line of communication 78 (assumed to be of the INCOM type) is connecting in a daisy line fashion the backpack units serially at their different locations. Line 78 leads to a P.C. Computer Station. Typically it passes through an optional Data Readout Station DAT, as explained hereinafter. The function of the communication line 78 is like the one explained fully in the context of a Personal Computer-Based Dynamic Burn-In System as in the specification of U.S. Patent No. 4,866,714.

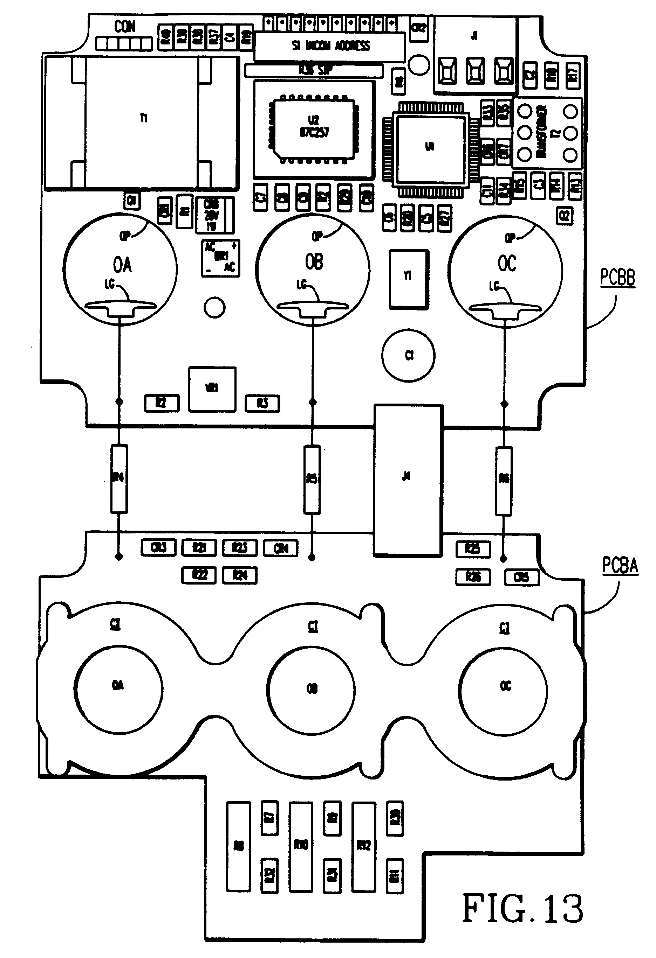

The previous Figure 8A showed two printed-circuit boards side-by-side with their main mechanical parts attached to it. Figure 13 illustrates the internal electrical organization about the central openings OP of board PCBB for the three phases with their respective radial lines 10 going through resistors R4, R5 and R6 from board PCBB to board PCBA. Connector J4 is illustrated as a ribbon RB connecting the signal outputs from board PCBA to board PCBB, for digital treatment.

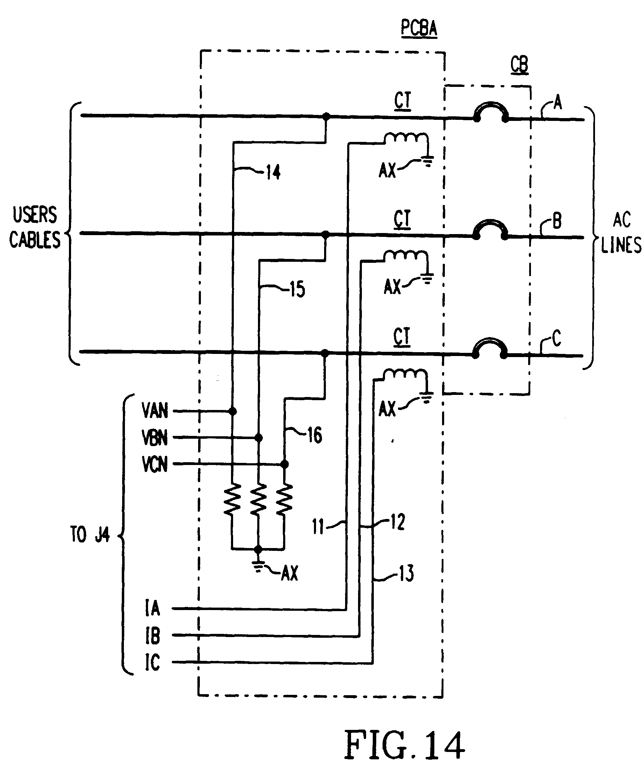

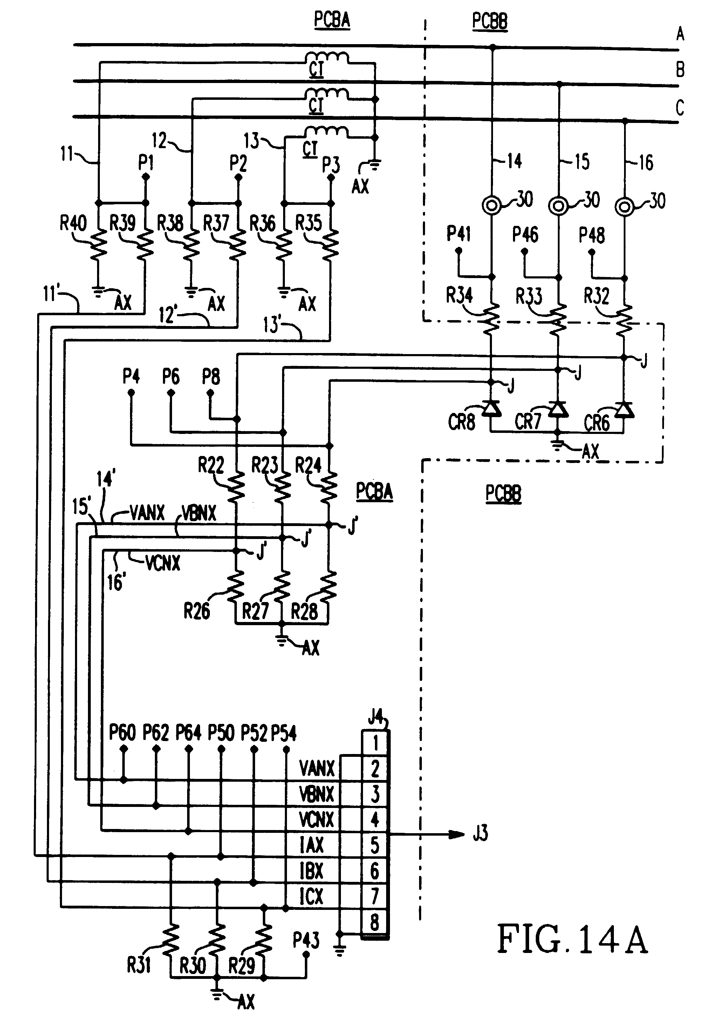

Figure 14 is a diagrammatic representation of the current and voltage sensing circuit embodied in the PCBA board. The three current sensing transformers CT are shown with the respective local cables which are in line (through the PCBA board and the circuit breaker CB) with the AC line phases A, B, C. The secondaries are providing the respective current (via lines 11, 12 and 13) signals IA, IB, IC for the other printed-circuit board PCBB. Similarly, at junction points with the lug LG, simulated by nodal points 30, which are the rivets of fixation of Figures 4A and 7, the voltages VAN, VBN and VCN are derived (via lines 14, 15 and 16) by reference to a neutral point AX. The circuitry involved is illustrated by Figure 14A. Line 11 from the A line secondary winding of transformer CT goes to the common ground AX through a resistor R40, whereas through a resistor R39 and line 11' it reaches pin 7 of connector J4. Similarly, for line 12 from the B line secondary winding of transformer CT and for line 13 from the C line secondary winding of transformer CT (resistors R38 and R37 with line 12', in one instance, resistors R36 and R35 with line 13', in the second instance) go to respective pins 6 and 5 of connector J4. The three lines 11', 12' and 13' are also connected to the common ground via resistors R31, R30 and R29, respectively. With regard to voltage sensing, from rivet 30 respective series networks (resistors R34, R33 and R32 and corresponding rectifiers CR8, CR7 and CR6) are connected to the common ground AX, with their nodal points J going, by respective lines 14, 15, 16, through two series resistors (R22, R24; R23, R27; R24, R28) to the common ground AX. From the nodal points J' between resistors, respective line 14', 15' and 16' are derived and applied to pins 4, 3, 2 of connector J4, respectively. Thus, connector J4 which belongs to printed-circuit board PCBA is available for connection through a ribbon RB to a similar connector J3 present on printed-circuit board PCBB for receiving the derived signals representative of IAX, IBX and ICX (for the phase currents IA, IB and IC of the AC lines) and of the derived line-to-neutral voltages VANX, VBNX and VCNX.

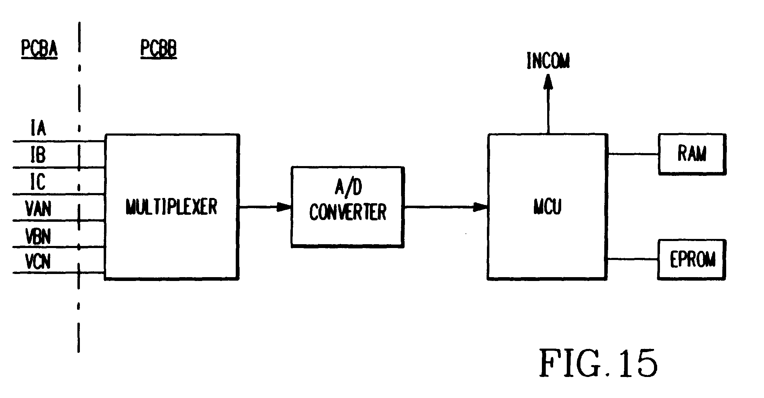

Figure 15 is a schematic view of printed-circuit board PCBB receiving, on one side, the sensed currents and the sensed voltages (IA, IB, IC, VAN, VBN and VCN) and communicating, on the other side, with the INCOM line which is a bi-directional line of communication with the PC computer. A multiplexer responds to the inputted analog current and voltage signals which are converted from analog to digital by an A/D converter. The digital signals so obtained are treated digitally for information processing and control by a microcomputer MCU using RAM and EPROM devices. As a result, at each local station involving two printed-circuit boards PCBA and PCBB ,as shown in Figure 15, local information and control commands are sent through the INCOM system to the PC computer for central energy monitoring.

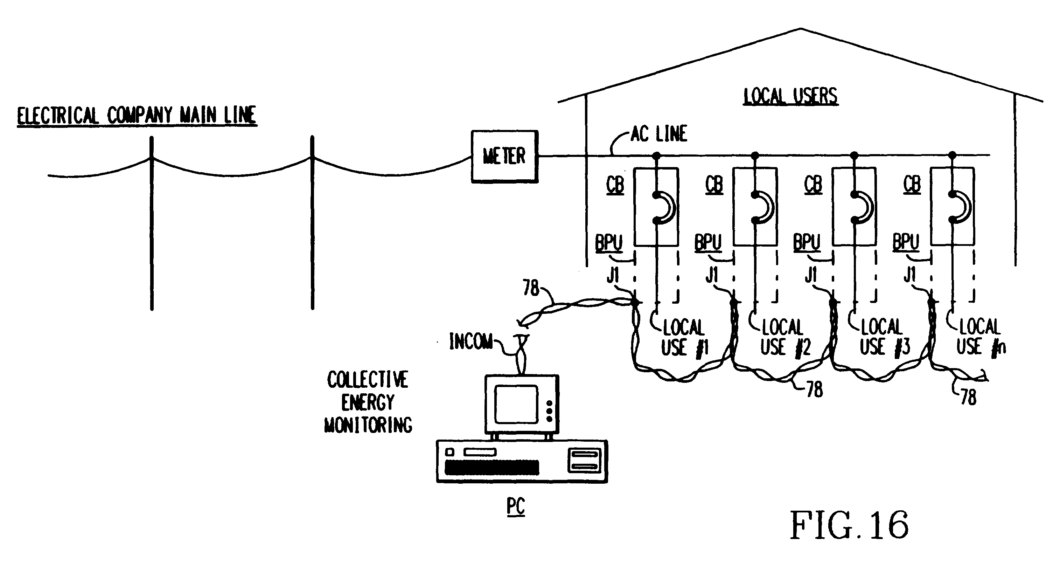

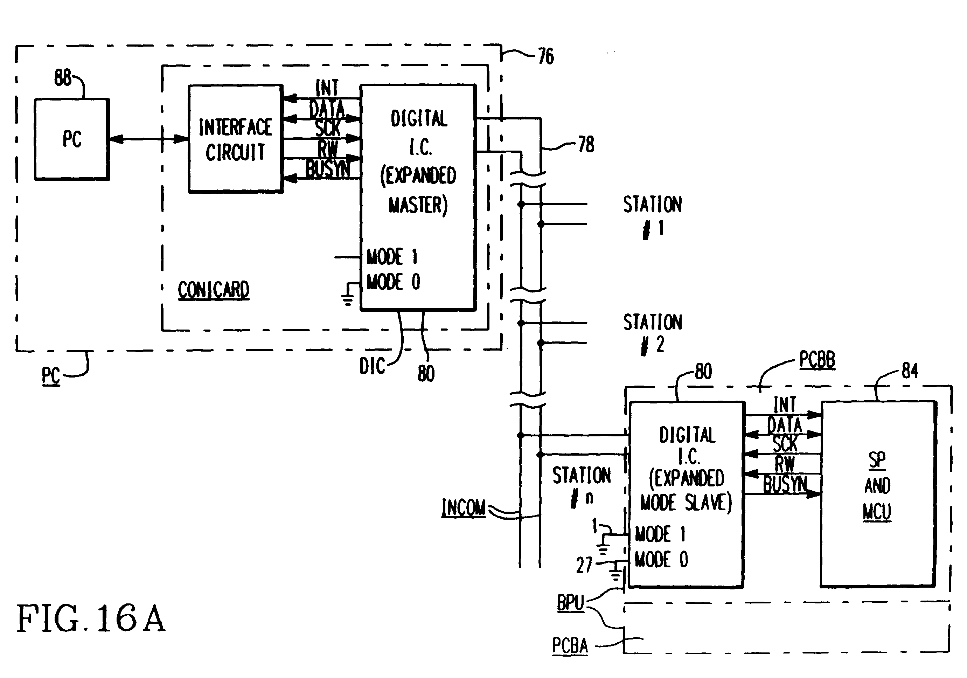

Figure 16 provides an overview of the energy monitoring system according to the present invention. The electrical company main line is arriving at a meter in front of the building where there are several local users (#1, #2, #3..#n), each supplied from the main line through an individual circuit breaker CB, belonging to a panelboard. The backpack units BPU are shown mounted each upon one circuit breaker. From the INCOM junction J1 of each backpack unit, a daisy line 78 is interconnecting all the local PCBB boards to the PC computer station PC for energy monitoring and individual billing. For instance, the distribution of energy consumed behind the common meter is 20% for user #1, 10% for user #2, 0% for user #3 and 30 % for user #n.

Figure 16A is similar to Figure 1 in the specification of U.S. Patent No. 4,644,547 which relates to the interface between a two-way communication network of the INCOM type. Transposed to energy monitoring as the present field of application, the printed-circuit PCBB fulfills the role of blocks 80 and 84 in a local station operating as an expanded mode slave.

In Figure 16A, the PC station is indicated at 76 as the central controller which transmits and receives messages from the several remote stations over the bidirectional transmission line 78 of the INCOM. The PC computer communicates with a conicard including an interface circuit and a digital integrated circuit (DIC 80) operating as an expanded master. At the receiving end, there is another digital IC 80 operating in the expanded mode slave. These two units insure a dialog over line 78 between the two ends. Each of the digital IC's 80 is provided with a so many bits address field so that they can be addressed individually. In the expanded slave mode, the digital IC 80 responds to a particular command from the central controller 76 by establishing an interface with the local microcomputer MCU indicated at 84 as part of a Sure Plus Chip SP, within printed-circuit board PCBB. The digital IC 80 responds to an enable interface instruction in a message received from the central controller 76, by producing an interrupt signal on the INT line to the microcomputer at 84 permitting the latter to read serial data out of a buffer shift register over the bidirectional DATA line, in response to serial clock pulses transmitted over the SCK line from the MCU to the digital IC 80. The digital IC 80 also responds to a signal on a read write line RW from the MCU by loading serial data into the buffer shift register of the device from the DATA line in coordination with serial clock pulses supplied over the SCK line from the MCU. The digital IC 80 will respond to a change in the potential logic of the RW line by the MCU by incorporating the data supplied to it from the MCU in a so many bit message formatted to include all of a standard message transmitted by the central controller 76. As a result, the expanded slave device 80 enables bidirectional communication and transfer of data between the central controller 76 and the local MCU over line 78 in response to a specific enable interface instruction initially transmitted to the local expanded slave device 80 from the central controller. This interface remains in effect until the digital IC receives a message including a disable instruction, or until there is a command addressed to a different local station. There is also a busy signal over line BUSYN to the MCU whenever device 80 receives, or transmits, over line 78. For the purpose of disclosing the INCOM system in an expanded slave relationship with a local station.

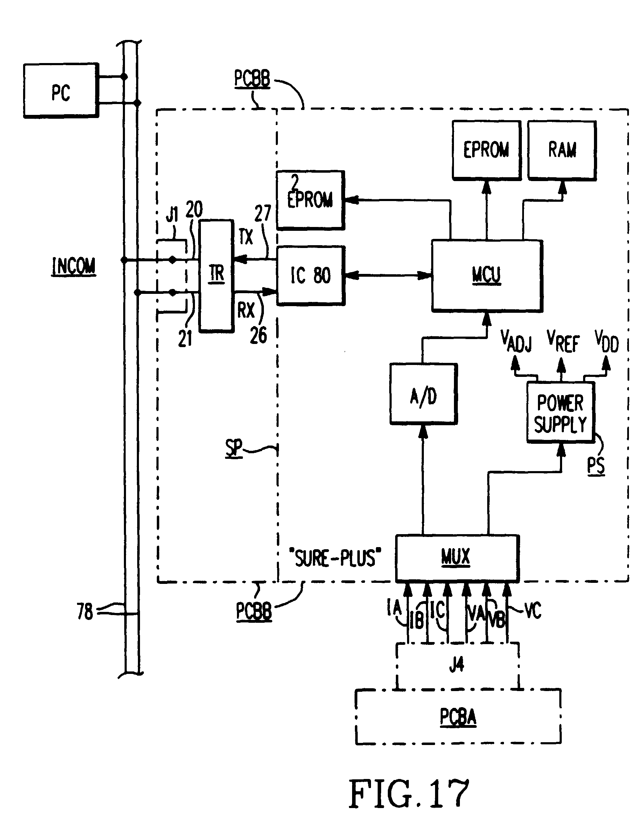

Figure 17 is specific to the relation between the INCOM line 78 and the Sure Plus Chip SP. Within the PCBB board, a transmitting-receiving interface circuit TR is provided between the PCBB connector J1 and the SP digital device IC 80. It relates the message, to or from the INCOM, to the transmitting signal TX (message coming from the IC 80 to be transmitted on the INCOM to the PC computer) or to the receiving signal RX (message arriving on the INCOM for the addressed local station and to the IC 80). Figure 17 also shows the MCU centrally disposed within chip SP, energized by the power supply PS and receiving the PCBA signals through the multiplexer MUX. An EPROM, an EEPROM (E2) and a RAM device are also provided within the PCBB board to assist the operation of the MCU.

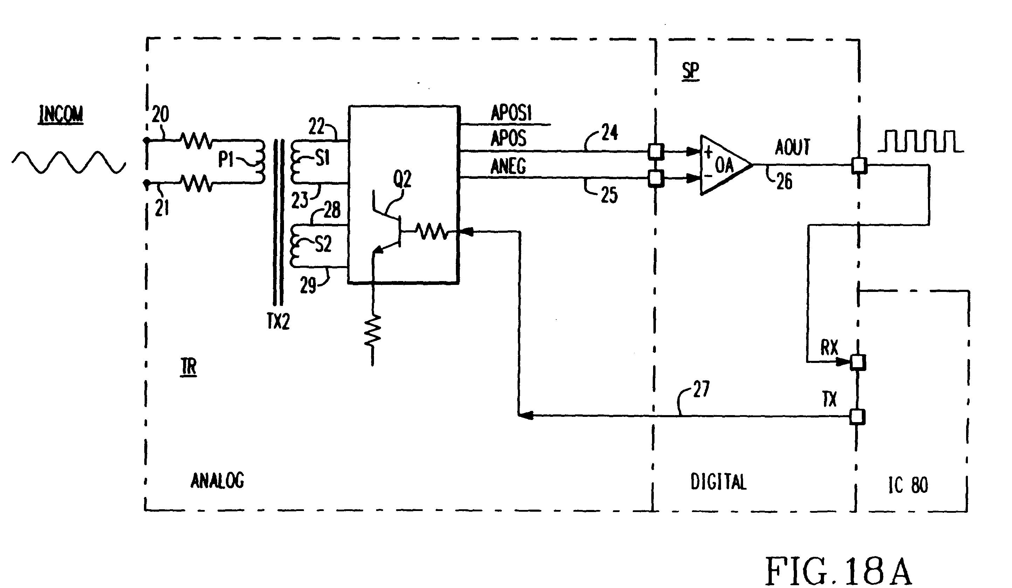

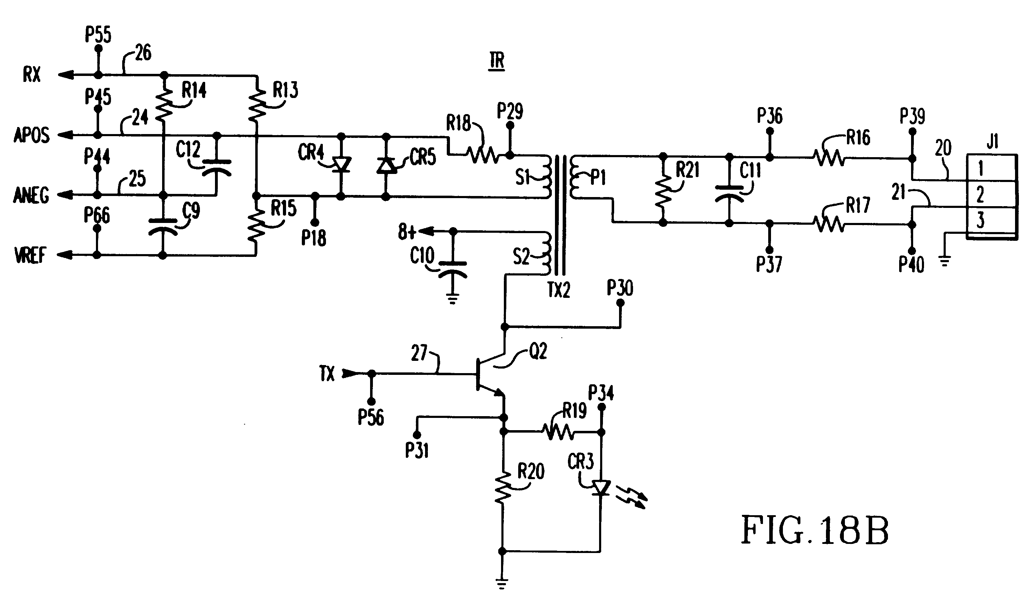

Figure 18A is a block diagram representing circuit TR of Figure 17. This is required because the high frequency signal characterizing each logic state of the transmitted message (address and data fields) of the INCOM has to match an equivalent logical state (based on a 5 volts potential) within the SP chip. Accordingly, at the input, namely, from connector J1 and the INCOM, lines 21 and 22 go to the primary P1 of a transformer TX2, the secondary S1 of which, by lines 22 and 23, go to circuitry centered on a solid state device Q2 (hereafter explained by reference to Figure 18B) with an output line 24 carrying a signal APOS and an output line carrying a signal ANEG matching the alternate peaks of the input analog signal of lines 20 and 21. Lines 24 and 25 enter the chip SP and become the respective positive and negative inputs of an operational amplifier OA outputting on line 26 a signal AOUT which is the digital counterpart of the inputted analog signal of lines 20 and 21. Line 26 becomes for the IC 80 device the received signal RX from the INCOM system. Conversely, line 27 from the IC 80 device is transmitting from the PCBB board a digital signal TX which is applied to the base electrode of the Q2 device, thereby leading through transformer TX2 to an outputted signal, for connector J1 and the INCOM, supplied by lines 20 and 21 of the primary winding P1 in response to lines 28 and 29 of secondary winding S2.

Figure 18B shows specific circuitry used according to the preferred embodiment of the invention for circuit TR. Device Q2 is a 2N2222 transistor. It is mounted in series with the secondary winding S2 of TX2 between resistor R20 to ground A on the emitter electrode side and a 8v potential beyond winding S2, on the collector electrode side. Potentials RX (line 26), APOS (line 24), ANEG (line 25), VREF (line 28) are outputted on the side of secondary S2.

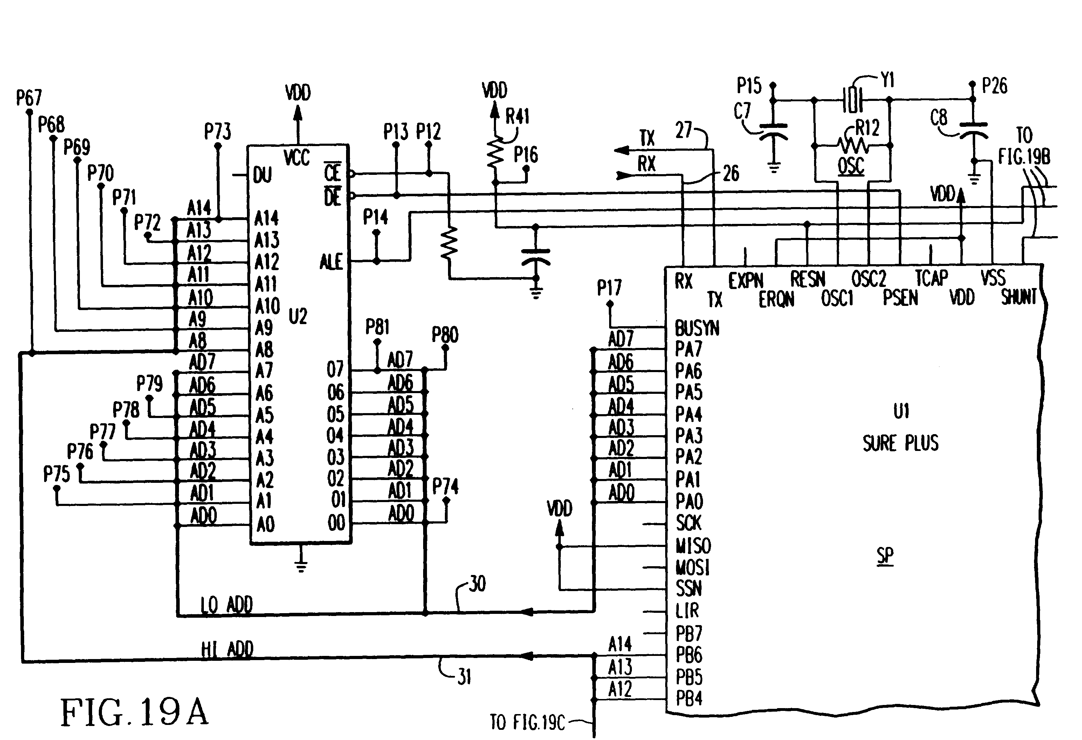

Figures 19A-19C provide a detailed description of the circuitry involved in the printed-circuit board PCBB, with a SURE PLUS Chip U1 at the center. The Sure Plus Chip unit U1 involves a microprocessor (model 87C257 on the market). It is based on a MC68HCO5CG Single-Chip Mode Pinout (of Motorola), which is a 80 Pin Quad Flat Package. It includes, associated with the microprocessor, a random access memory (RAM) for the purpose of writing data to be saved, or reading saved data. It also includes an EEPROM device, which is an electrically erasable programmable memory, for the purpose of being a non-volatile memory, e.g. which will not be erased upon an unexpected loss of power. The U1 unit also includes the power supply PS and the AID conversion unit of Figures 15 and 17. The IC 80 device is also included in the SP.

Figures 19A-19C show associated with the SP unit U1, a device U2 which is an erasable programmable read only memory (EPROM) also shown in Figure 17. Its purpose is to provide a prbgrammed memory to be used by the central processing unit constituted by unit U1. The two units communicate with one another through lines 30 and 31, which relate to the LO-ADD field and the HI-ADD field of the message exchanged. One is for the address field, the other for the data field An oscillator OSC is provided to establish the timing of the digital processing seguence.

Figures 19A-19C show lines 26 and 27 affected to received and transmitted signals (RX, TX) regarding the INCOM, with their corresponding pins (80 and 79) on the U1 unit. The multiplexer MUX is illustrated by arriving points MUX7 to MUX0 (pins 52 to 59) for the PCBA board signals VCN, VBN, VAN, IC, 1B, IA, respectively. Pins 24 to 34 correspond to the logic bits established between contacts 1 to 10 and 11 to 20 for the local address of the user's station involved. This address will be identified by the MCU to match the incoming, or the outgoing message, when a message has to be received, or transmitted. Pins 49, 48 and 47 correspond to signals RX, ANEG and APOS of lines 26, 25 and 24 of Figure 18A. The power supply PS provides a reference voltage VREF (pin 62) and a regulated supply AVDD (pin 50). The microprocessor generates a signal ALE (pin 66) used as the "address latch enable" recognizing the relevant address in the message, and which is sent by the MCU to the EPROM. Thus, program execution is performed according to PA7 to PA0 for the HI-ADD, PB2 to PB6 for the LO-ADD in relation to the EPROM. AID conversion is effected in response to the multiplexer inputs (pins 51 to 60). Power supply outputs are on pins 62, 63. INCOM reception is on pins 47 to 49. INCOM transmission is on pins 79, 80 and 1.

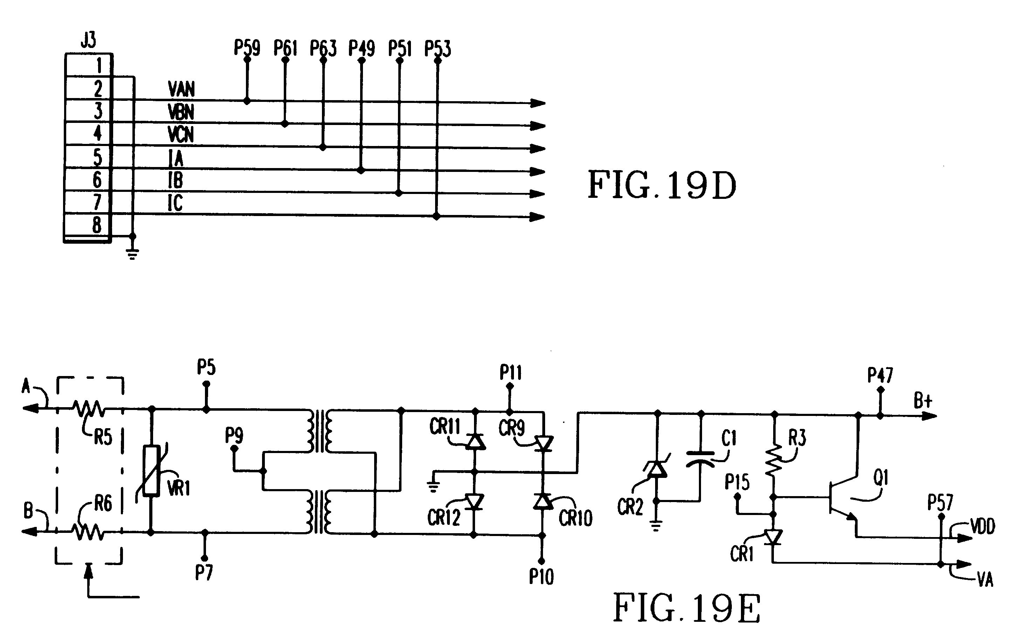

Figure 19D illustrates the connections between the J3 connector and the VAN, VBN, VCN, IA, IB, IC receiving pins of the chip SP. Figure 19E illustrates the circuitry of the power supply derived from phase lines A and B for VA and VDD.

Having described the circuitry involved in the preferred embodiment of the invention, the operation of the energy monitoring system according to the present invention will be described in the context of the afore-stated combination of an INCOM system and a SURE PLUS Chip system.

The main function at a local station is to determine instantaneously the energy consumed. Such local determination is based on sampling of the phase voltages and of the phase currents. Power is the product of V (the voltage) and I (the current). E (the energy) is the sum of the sampled products $VA \times IA$, $VB \times IB$ and $VC \times IC$. According to the present invention, sampling is preferably effected according to a sampling rule defined by the following TABLES I and II. Sampling is performed by groups of 8 samples, each referred to hereinafter as an octave. Within such octave, or group of 8 samples, the samples are labelled 0 to 7, each of which being triggered so that an odd number sample occur at 90 degrees from the preceding even number sample, and that an even number sample occur at 112.5 degrees after the preceding odd number sample. Therefore, the succession for the first octave will be according to TABLE I herebelow, the degrees being counted in electrical degrees of the sinewave for the voltage VA, VB, VC), or for the current (IA, IB, IC).

TABLE I

| OCTAVE # 1 (origin Oo at zero degree) | |
|---|---|
| Angle Theta | Sample No |
| 0.0 | 0o |
| 90.0 | 1 |
| 202.5 | 2 |
| 292.5 | 3 |
| 45.0 | 4 |
| 135.0 | 5 |
| 247.5 | 6 |
| 337.5 | 7 |

The rule will also be that from one octave to the next there will be a delay of 98.4 degrees. Therefore, if the first sample of the next octave starts at 01, the latter will be at 98.4 degrees relative to Oo. Similarly, the next octave will start at O2, which corresponds to $2 \times 98.4 = 196.8$ degrees. Therefore, the fifteen subsequent octaves after the octave of TABLE I will be according to TABLE II herebelow:

TABLE II

| Angle Theta | OCTAVES # 2 to # 16 |
|---|---|
| 98.4 | 01 |
| 196.8 | 02 |
| 295.2 | 03 |
| 33.60001 | 04 |
| 132 | 05 |
| 230.4 | 06 |
| 328.8 | 07 |
| 67.19998 | 08 |
| 165.6 | 09 |
| 264 | 10 |
| 2.399964 | 11 |
| 100.8 | 12 |
| 199.2 | 13 |
| 297.6 | 14 |
| 35.99997 | 15 |

After such a succession of 16 octaves, thus a total of 128 samples, the same sampling process is repeated with a delay of 120.94 electrical angles.

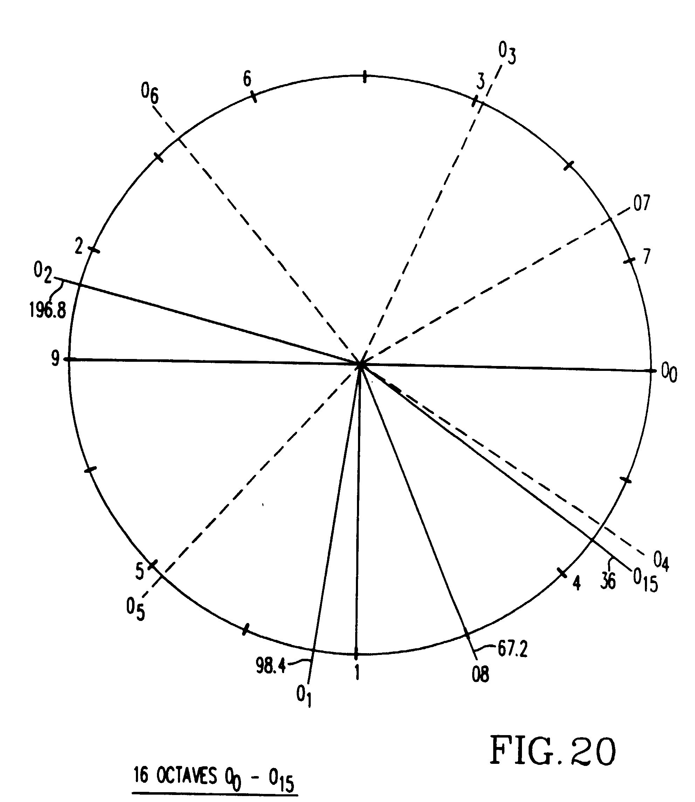

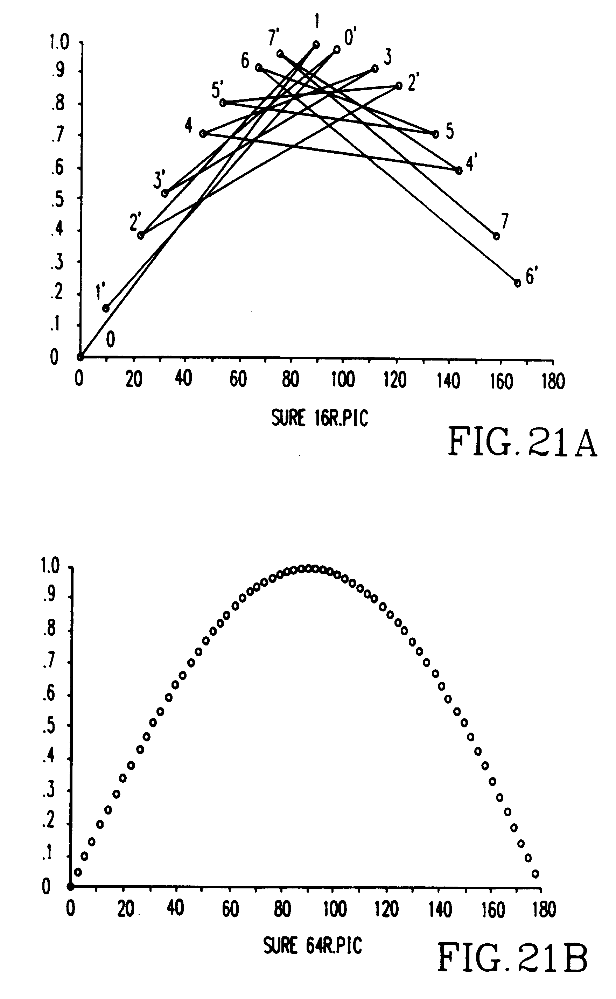

It will be observed that this amounts to distributing the 8 samples of an octave evenly over a half-cycle of the sine wave. This will appear first from Figure 20 wherein the eight samples Oo to 7 of the first octave are shown distributed around the trigonometric circle. 01 appears at an angle of 98.4, which represents a delay of 98.4 + 22.5 = 120.9 degrees from the last sample 7 of the first octave. Similarly, the first samples in the successive 15 octaves are spread from 02 (at 196.8 degrees) to 015 (at 36 degrees). Each octave has its samples distributed at 22.5 (90/4) and at 45 degrees (90/2) from one another. Also, as shown by octaves 08 and 016, after 8 octaves the sample of one octave falls upon one of the original 90/4 divisions of the circle. Referring to Figure 21A, the seven samples 1 to 7 for a group of 8 samples initiated at a zero-crossing (0 degree) are shown in relation to a half-cycle of the fundamental wave. The next octave is shown distributed in between, as indicated with prime numbers. Figure 21B shows the corresponding half-cycle. From these two Figures it appears that the sampling process generates a cumulative series of samples distributed closely side-by-side along the sinewave, thereby maximizing the accuracy. This is performed for each of the three phases of the voltage VA, VB, VC and of the current IA, IB, IC. In Appendix D is given a Listing of the Sampling for the 8 octaves. Having locally sampled voltage and current with the microcomputer and the adjunct circuitry within the SURE PLUS chip, the object is to establish instantaneously how much has been accumulated locally of Energy and of the Demand, and to have such information ready to be read, or withdrawn, by the PC computer through the INCOM. Therefore, the PCBA printed-circuit will first provide the analog signals inputted into the Sure Plus chip SP, which is part of the PCBB printed-circuit, where A/D conversion is performed by the microprocessor MCU, and where calculation of the product VxI occurs continuously and instantaneously.

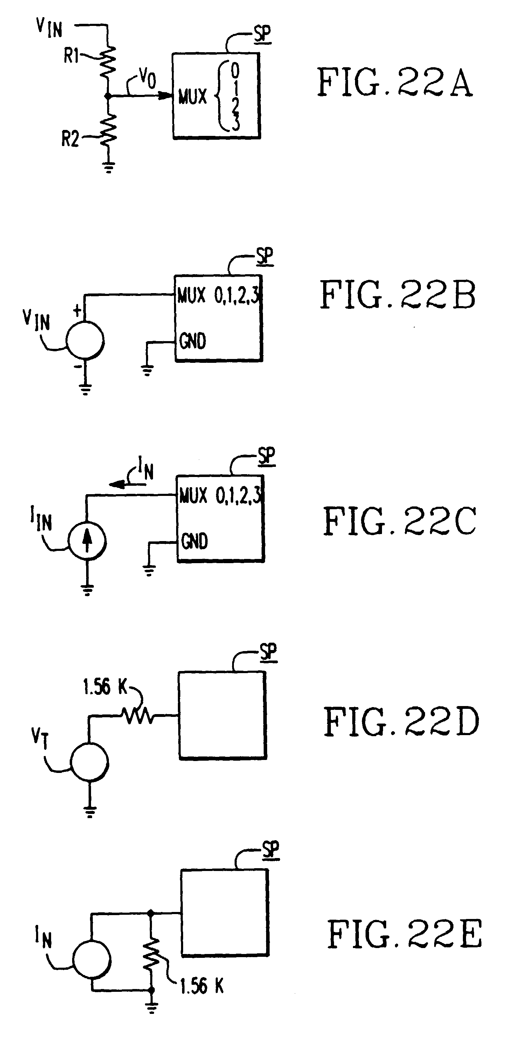

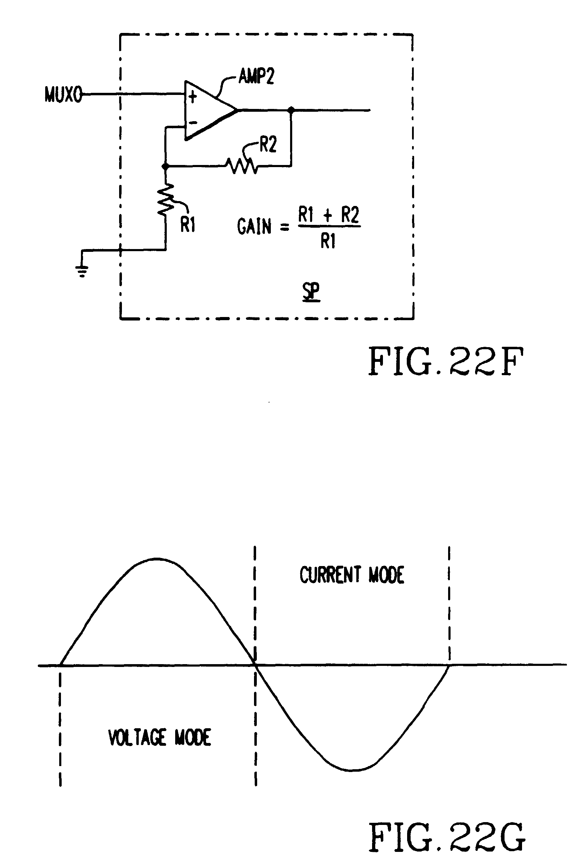

Referring to Figure 22A, the input signal from the PCBA printed-circuit is derived from the midpoint between two serially connected resistors R1, R2 connecting the input voltage VIN to ground. The output voltage Vo goes to the multiplex pin (MUX0, MUX1, MUX2, or MUX3) of the chip SP. A/D conversion is performed for the phase currents IA, IB, IC as sampled. In the process, circuitry within the chip SP will create a return to ground. Two situations arise. One is a high impedance input, typical of a voltage source (as illustrated by Figure 22B), the other (corresponding to a current source) is a very low input impedance amounting to a short-circuit (as illustrated by Figure 22C). In the first instance, the chip SP will be said to operated in the voltage mode, whereas in the other instance the operation will be said to be the current mode. In the voltage mode, the chip will operate from 0 to a maximum voltage of + 2.5 volts. In the current mode, current is flowing from the chip SP (negative current) with a maximum value of -1600 microamperes. If an input signal source is designed to have an output impedance of 1.56k ohms which is equal to the full scale voltage divided by the full scale current, both current and voltage modes can be used without any additional scaling factors. This situation is illustrated by Figure 22D (also known as the Thevenin equivalent) and by Figure 22E (also known as the Norton equivalent). As shown by Figure 22F, the chip SP is internally designed so as to immediately adopt under MCU operation either the voltage or the current mode, depending upon whether the input is VIN (high input impedance), or IIn (short circuit input). Between the multiplex input (MUXO) and ground (GND) are the respective negative and positive inputs of an operational amplifier AMP1 which is designed for auto-zero operation. In the "current mode", a feedback loop between the operation amplifier output and the negative input includes the gate electrode G and the source electrode S of a FET device Qo such that, when an input causes a VIN negative current to flow from the chip SP, the output of the amplifier is driven positive until the source electrode S supplies a current equal to the VIN current holding the input at zero volts. This is the short-circuit input, or "current mode". In the "voltage mode", amplifier AMP1 and FET device Qo are disabled and any positive voltage Vo appearing at pin MUX0 will be translated by normal amplification through a second amplifier AMP2. In the "voltage mode", amplifier AMP2 offers a high impedance to VIN and an essentially zero current flows from MUX0, so that pin MUX0 follows the input signal VIN in the "voltage mode", instead of being "zero" as in the "current mode". Considering now Figure 22G which shows a full cycle of the fundamental, when the signal is positive (first half-cycle) the operation is in the "voltage mode". When the signal is negative (second half-cycle) the operation is in the "current mode". Having explained what are these two modes provided with the chip SP, it will be observed that whenever there is A/D conversion, only the positive voltage of the voltage phase sample is used whereas, for current sampling the current may be either positive, or negative. For current sampling, if it is positive (first half of the curve of Figure 22G) A/D conversion in the voltage mode will take place. If it is negative, as shown by Figure 22F there will be a zero output in the "voltage mode". Zero means a "current mode" situation, and A/D conversion will be done again in the "current mode" according to Figure 22C, or Figure 22E.

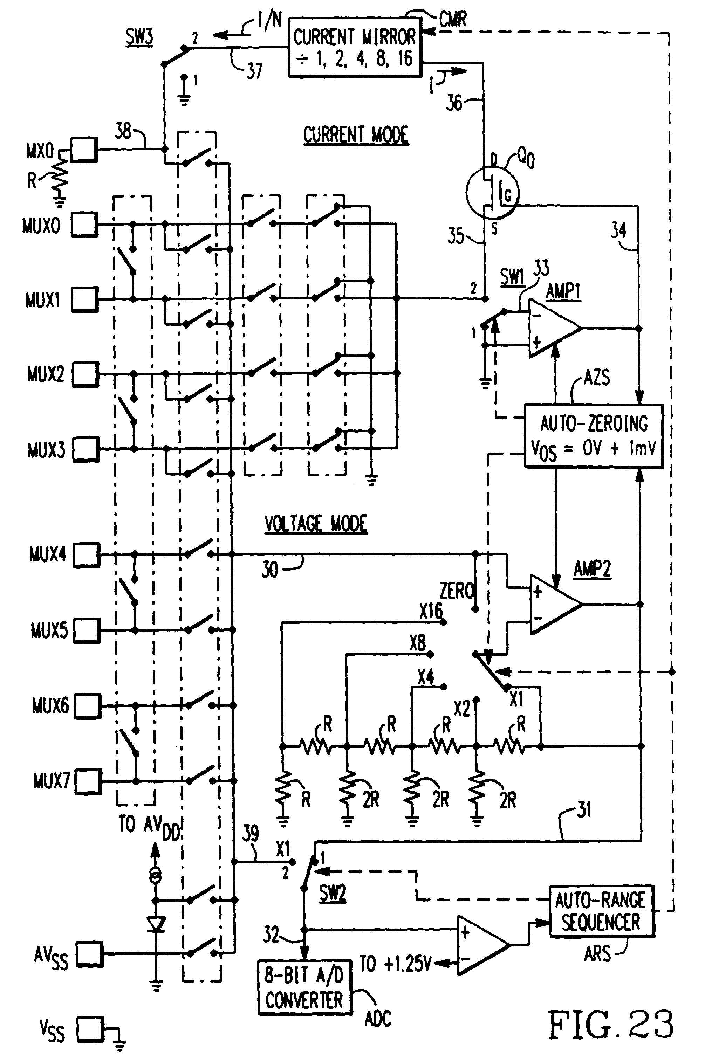

The analog voltage/current measurement system of Figure 23 can accurately measure in the voltage mode input voltages from 0 to + 2.5 volts and input currents from 0 to - 1.6 milliamps. In the best embodiment of the invention, it includes as major features:

- An 8-bit analog-to digital converter ADC;
- An auto-ranging system ARS used for input scaling;
- An auto-zeroing controller AZS applied to input amplifiers AMP1 and AMP2;
- An 8 channel input signal multiplexer (MUX0-MUX7);
- 4 channels that can read currents and voltages for phase current sampling;
- 4 channels that are used for voltage input only for phase voltage sampling;
- Up to 4 sample-and-hold voltage inputs.

All voltage inputs are buffered by a variable gain, auto-ranging voltage amplifier AMP2 before entering the A/D converter ADC. The voltage amplifier's gain is automatically adjusted until the signal is at least one-half of full scale, but not in overflow. Voltage measurements can be made directly or by using a sample-and-hold (integrating) technique. Sample-and-hold measurements require two adjacent input channels configured for "voltage mode" and an external capacitor. All four sample-and-hold input channel pairs are samples simultaneously.

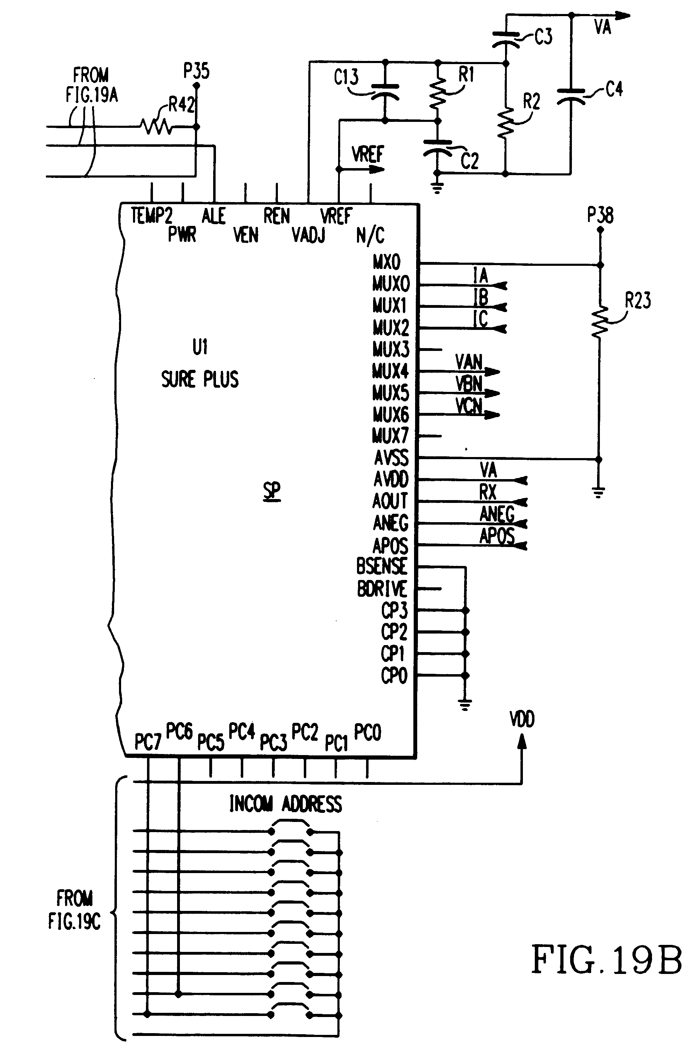

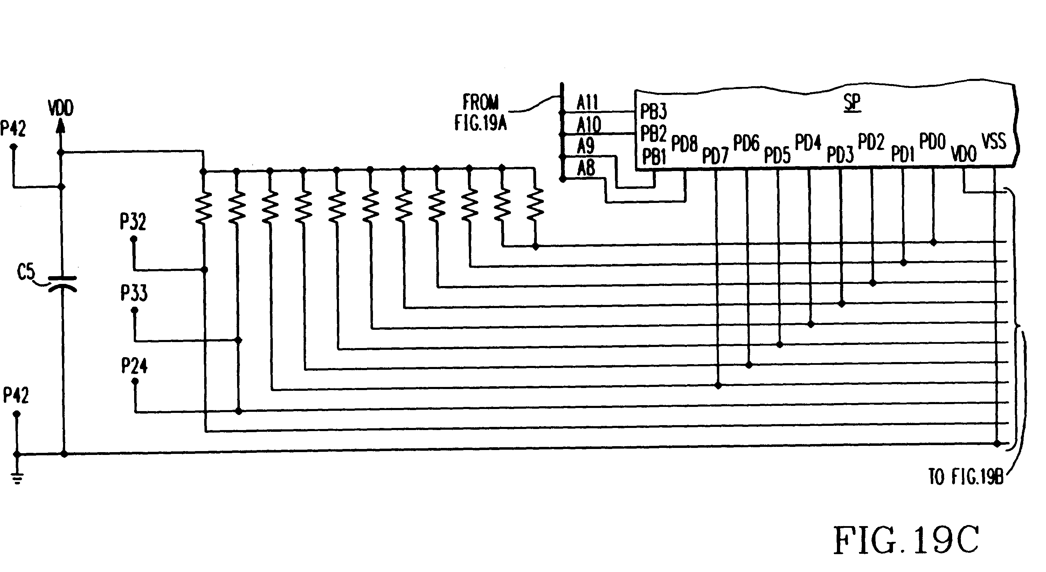

When measuring negative current, an amplifier AMP1 is used, and the operation is in the "current mode". It accepts negative currents (namely, currents flowing out of the input) and it can be operated in either an integrating or non-integrating mode by connecting either a capacitor, or a resistor (shown at R23 in Figure 19) to the MX0 pin. The amplifier AMP1 is designed so as to maintain its inverting input at a virtual ground by providing current to the selected channel through an auto-ranging current source, known to operate as a current mirror (CMR). Current flowing out of the current source directed at the MX0 pin represents a programmable fraction of the current flowing out of the selected input channel. Other sections shown in Figure 23 relate to:

- An internal shunt regulator for AVDD;

- A power supply monitor to signal external devices so that the AVDD shunt regulator is no longer drawing current;
- An adjustable band gap voltage reference;
- A fixed bandgap voltage reference.

The system of Figure 23 pertains to the internal organization of the SURE PLUS chip and of the microprocessor operation therein, for A/D conversion in either the "voltage mode" of the "current mode". There, are shown the multiplex pins MUX0 to MUX3 for the inputted currents IA, IB, IC (coming from lines 11, 12, 13 of the PCBA printed-circuit, and MX0 connected to ground through a resistor R23 (Figure 19). Similarly, there are the multiplex pins MUX4 to MUX7 for the input voltages VAN, VBN and BCN. In the latter instance, which is the "voltage mode", the input voltage VIN is applied by line 30 to the non-inverting input of operational amplifier AMP2. The output goes, via line 31, and switch SW2 in position #1 onto line 32 as an input to the A/D converter ADC. The same will occur for the input currents, provided they are representing a "positive current" (switch SW2 still in position #1). The signals go to line 30 and are translated into an input on line 32 for the A/D converter ADC. If, however, the input current is "negative", the operation will be performed in the "current mode". Now, switch SW2 and switch SW1 are in position #2. The input current from MUX0 - MUX3, will be entering operational amplifier AMP1 by line 33. The output on line 34 is applied to the gating electrode G of a FET device Qo, so that on line 35 and through the source electrode and the drain electrode D a negative current is drawn from line 36 which comes from a current mirror circuit. Therefore, a corresponding current will flow from line 37 at the output thereof, which is converted by resistor R23 to ground into a voltage on pin MX0 which will by line 39 become an input on line 32 for the A/D converter ADC.

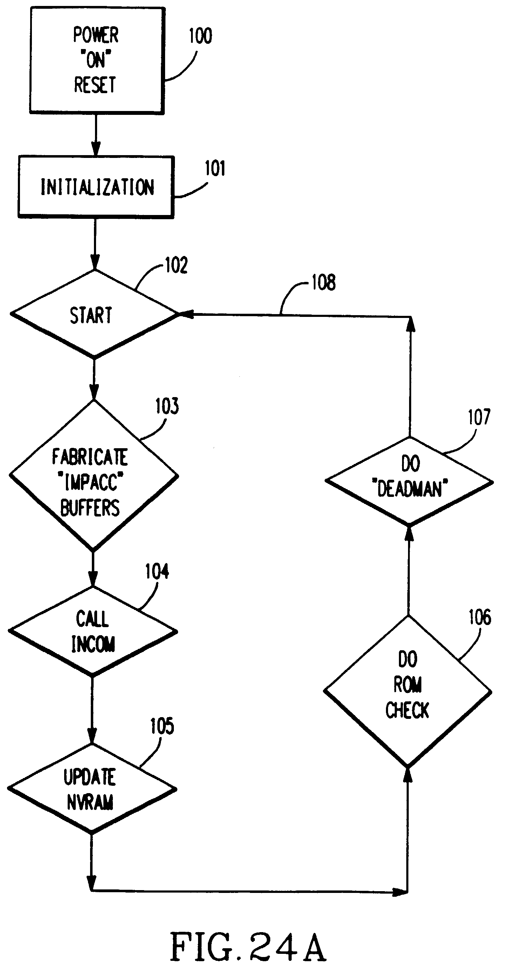

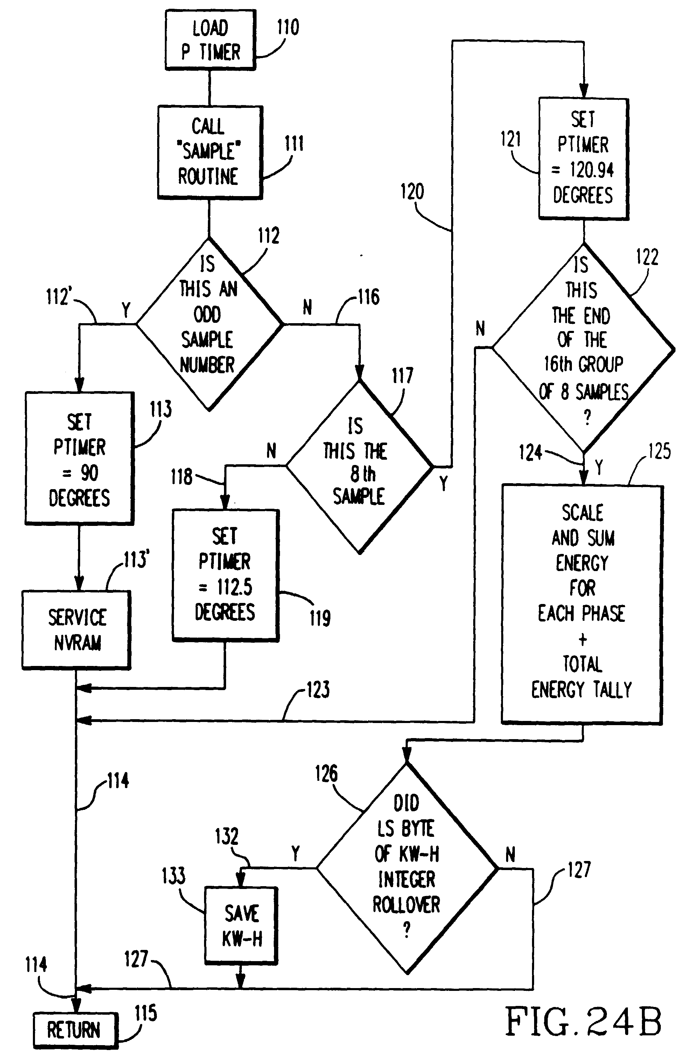

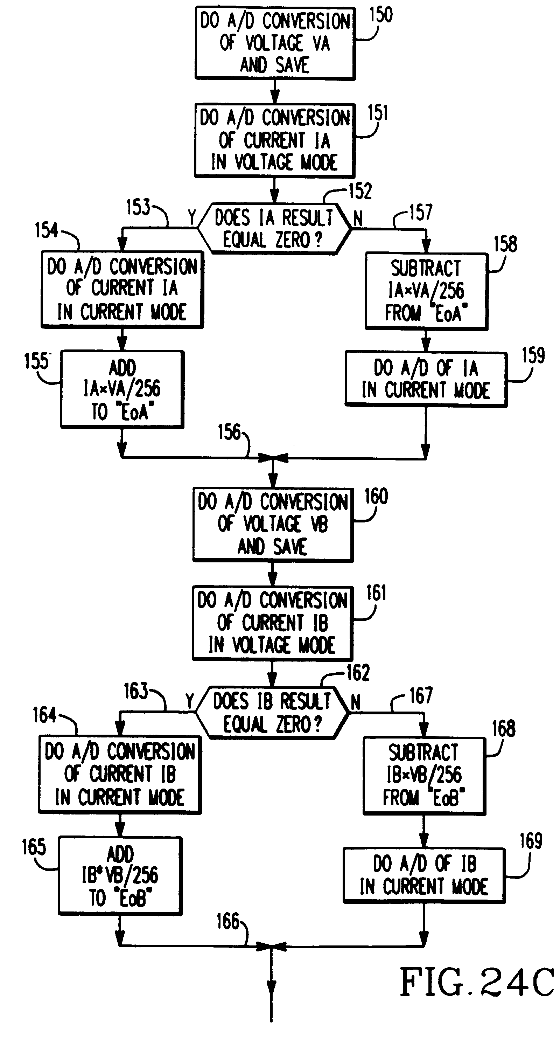

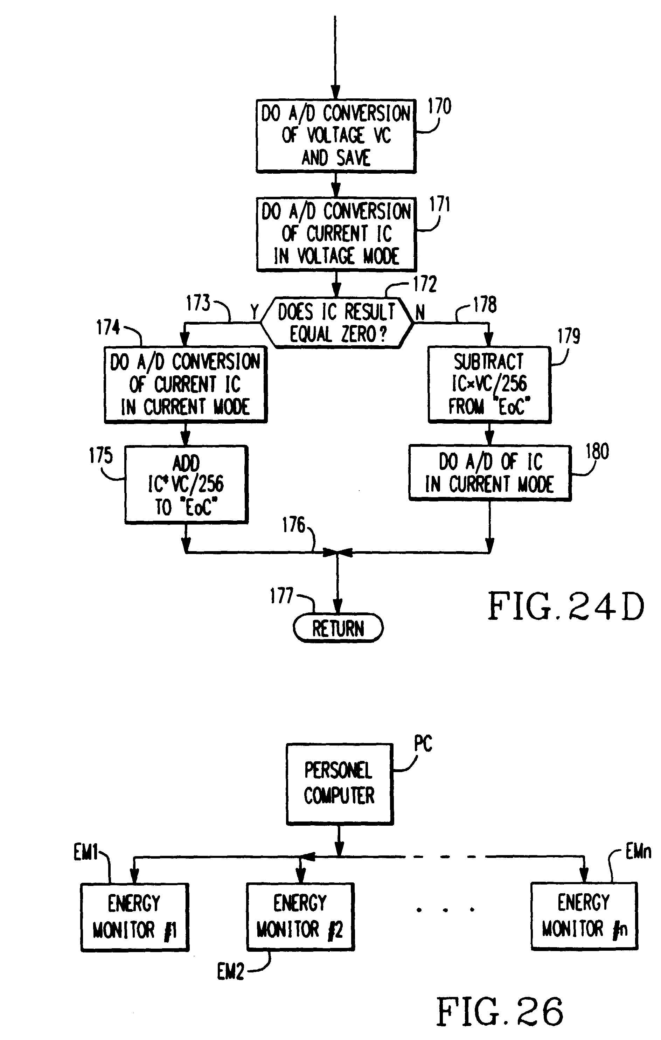

Figures 24A, 24B and 24C are flowcharts illustrating the operation of the MCU in performing energy monitoring at the local station. The flowchart of Figure 24A is the Main Routine. At 100 the power is ON, namely Reset. Then, at 101 takes place the Initialization step. At 102 the system starts ("Begin"). At 103 the step is to Fabricate the "IMPACC" buffers, relating to communications of information. At 104, the system calls the INCOM. At 104 the step is to Update NVRAM (the non-volatile RAM). At 106 comes up "Do ROM Check", thus involving the ROM. At 107 is "Do DEADMAN" a feature generally known from the SURE PLUS (SP) operation.

Referring to the flowchart of Figure 24B, this is the Interrupt Routine that the system effectuates for 60 Hz operation. As stated earlier, the sampling will follow the sequence 120o, 90o, 112o,90o, 112o, 90o, 112o, 90, 120o over two cycles. At 110 the step is: Load "PTIMER". By PTIMER is meant here the software, associated with the internal timer of the microprocessor MCU, which is programmed so as to establish the time interval between interrupts in the sampling sequence, according to the afore-stated TABLE I and TABLE II, for the successive octaves. At 111, there is a call for the "SAMPLE" routine. After that, at 112, the question is raised: "is this an odd sample number?". If YES, by 112' the system goes to 113 where the PTIMER is set to 90 degrees, and there is Service of the NVRAM. Thereafter, it goes by 114 to 115 for RETURN. If there is a NO at 112, by 116 comes the question at 117: Is this the eighth sample? If the answer is NO, by 118 at 119 the PTIMER is set equal to 112.5 degrees, and by 114 it goes to 115 for RETURN. If the answer is YES, by 120 at 121 the PTIMER is set at 120.94 degrees. Then, comes at 122 the question: is this the end of the 16th group of eight samples? If the answer is NO, by lines 123 and 114, there is a RETURN at 115. If the answer is YES, by line 124 comes, at 125, the command to scale and sum the ENERGY for each individual phase and provide the total ENERGY tally. Thereafter, at 126 the question is raised "whether the (least significant bits) LS byte of the KW-H (kilowatt-hour) integer is to be rolled-over?" If YES, by line 132, at 133, the KW-H are saved, and a RETURN at 115 is taking place. If there is a NO at 126, there will be a RETURN at 115.

Referring to Figure 24C, the flowchart of the Sample Routine is as follows: At 150 the step is for phase A of the voltage: "Do A/D conversion of voltage VA and save the result". Then, at 151 is the step regarding phase A of the current: "Do A/D conversion of IA in voltage mode". Thereafter, at 152, comes the question: "Does the IA result equal zero?" This question, as earlier stated means that as it appears from Figure 22F, that the detected current was either zero or negative. If YES, by line 153, comes at 154 the step: "Do A/D conversion of IA in the current mode". Then, at 155, the next step is to use the sampling value and raise the tally: ADD IAx-VA/256 to "EoA". Here, the accumulated energy in the tally accumulator is divided by the number 256 for scaling purposes only. Assuming 8 bits, by multiplying the number of bits would be excessive. Therefore a division by 16x16 = 256 is used. Then, the system goes to line 156. If NO at 152, by line 153' comes (at 158) the step: SUBTRACT IAxVA/256 from "EoA" (where "EoA" is the accumulated energy in the buffer register and where, again, the division by 256 is performed for scaling purposes only). Subtraction takes into account the negative sign of the IA in the product IAxVA. Phase current conversions in the "voltage mode" are assigned a negative sign and phase current conversions in the "current mode" are assigned a positive sign. In either case, the system provides the latest energy tally. Also, for reason of symmetry, at 159 is added a step similar to step 154 which is: "Do A/D conversion of IA in the current mode". This step is useless as a performing step, but it parallels the step 154, and therefore adds a duration which matches the other side. Accordingly, the two paths have in the process a timely convergence at 156, from which the system will subsequently repeat the same series of steps with regard to phase B. At this stage 156, the energy calculation for phase A has been completed. The same series of steps will also take place from step 156 to step 166 for phase B (at 160 the A/D conversion of voltage VB and saving; at 161 the A/D conversion of IB in voltage mode; at 161 the test whether IB is equal to zero; at 162 the question whether the IB result is equal to zero leading on one side to an A/D conversion for IB in the current mode at 164 and at 165 <u>adding</u> IBxVB/256 to "EoB", or at 168 <u>subtracting</u> IBxVB/256 from "EoB", before doing at 169 the time factor required A/D conversion of IB in the current mode. Then, comes phase C with the same series of steps from step 166 to step 176. These steps involve: 1/ an A/D conversion of voltage VC with saving of the result at 170 and an A/D conversion of current IC in the voltage mode at 171; and 2/ (depending upon whether at 172 the result for IC is equal to zero, or not) there will be (at 174) an A/D conversion for IC in the current mode, followed at 175 by "<u>adding</u> ICxVC/256", or there will be (at 179) "<u>subtracting</u> ICxVC/256", a step followed at 180 by a perfunctory step (as before for the two other phases) consisting in doing an A/D conversion of IC in the current mode. The common RETURN is by line 176 at 177. As it appears from the last steps of the flowchart of Figure 24 C, after the A/D conversion at ADC (Figure 23) a 8-bit sample is derived of VA and IA, for phase A, of VB and IB for phase B, and of VC and IC for phase C, from which samples the Energy is by calculated by phase, to be totalized for the three phases, thus, leading to:

$$E = \Sigma \; VAxIA + \Sigma \; VBxIB + \Sigma \; VCxIC \qquad (1)$$

This amount of energy is continuously stored and accumulated leading to an instantaneous total for the local station. This is done by the backpack unit at all stations for the various local users, and the results are ready at any time to be withdrawn at the PC computer station from all stations for individual billing. This is used at the PC computer station, or any other chosen central station, to monitor the overall energy consumption, in parallel to the collective meter of the electrical company. There is also a need to know the Demand, which is a gradient of energy, namely Energy / Time. Every five minutes, for instance, the PC computer station will determine how much energy has been consumed in such a time interval. By a snapshot every five minutes, the PC computer station will cause each individual station to simultaneously store their instantaneous energy consumption. Between two snapshots, the central station will withdraw from each local station, sequentially, all such stored instantaneous energy consumptions and take the difference between the newest value and the prior value for each local station. This difference is the ENERGY consumed in five minutes, or 5 minute DEMAND, at such local station. This difference is, then, time stamped and user stamped by the central station, and saved for later use in determining how to distribute "DEMAND" billing costs among the local users.

As a general approach to a central monitoring of energy based on the apparatus and system which has been hereinbefore explained and described for one local user station, the several stations are storing and making available at any moment their results of totalized Energy, upon which the PC station will have only to call the results from each station one after the other. However, in order to match a collective reading by the common meter of the electrical company, there is a need to "synchronize" the polling of information from the local user backpack units. This is the problem solved by another aspect of the present invention, as seen from the PC station, or central station, rather than from the remote station.

It is known from the specification of U.S. Patent No. 4,692,761 to pass data relative to power consumption from remote stations to a central unit where the total amount of energy consumed is measured in relation to a centralized meter.

The prior art expresses the need for a true communication insuring a true message and a valid intercommunication. To this effect use has been made of periodical forwarding of data to the central unit, which are still subject to false information due to local operational defects. Combining an exact time relation between the local energy consumed with a reliable message communicated and received have required too much complexity in the dialogue between central unit and remote units. It is proposed now not to require synchronism between the local demand and energy calculations at the remote stations, but to require locally a storing of the instantaneous accumulation of energy by each local station at the command of the central station called "snapshot". The central station, then, reads these local energies in order to determine the energy used between two "snapshots". The passivity of the remote stations insures a constant determination of energy locally, whereas the intervening snapshot from the central unit insures a proper timing which is less demanding than an assigned synchronism of the remote stations.

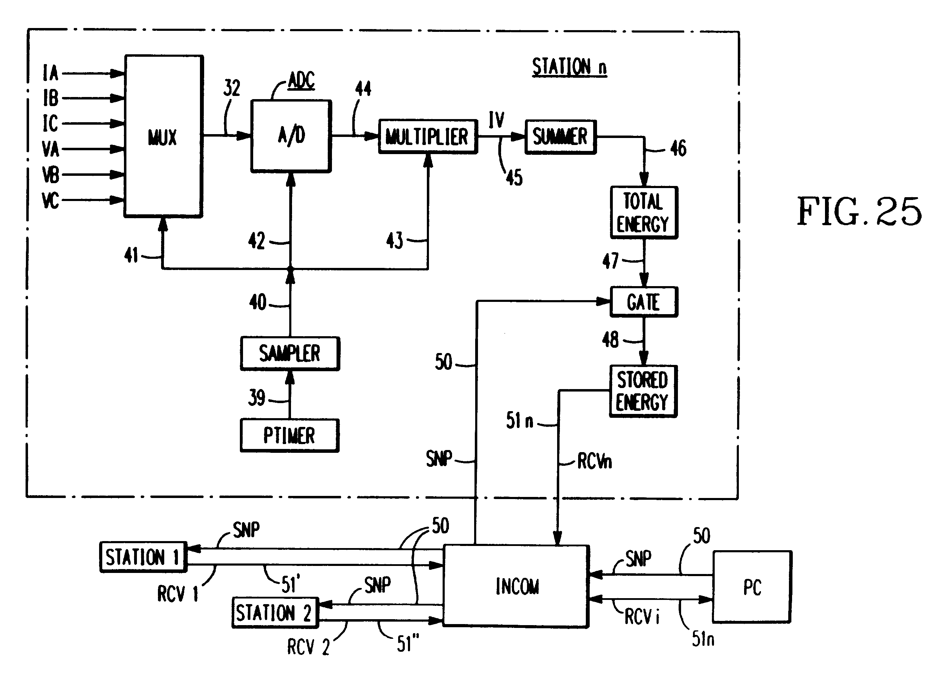

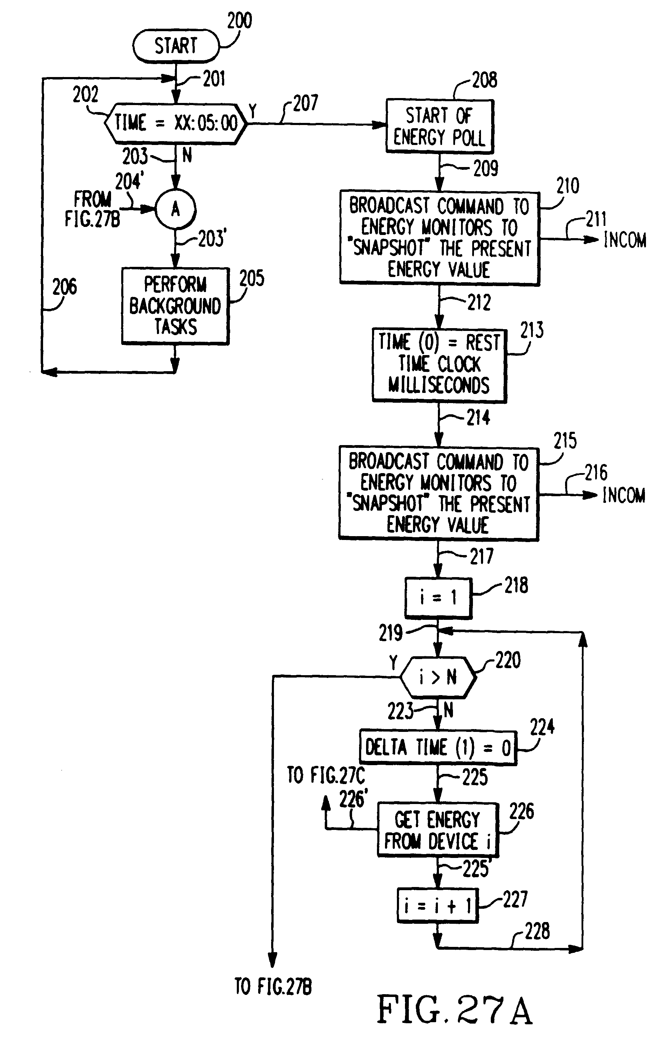

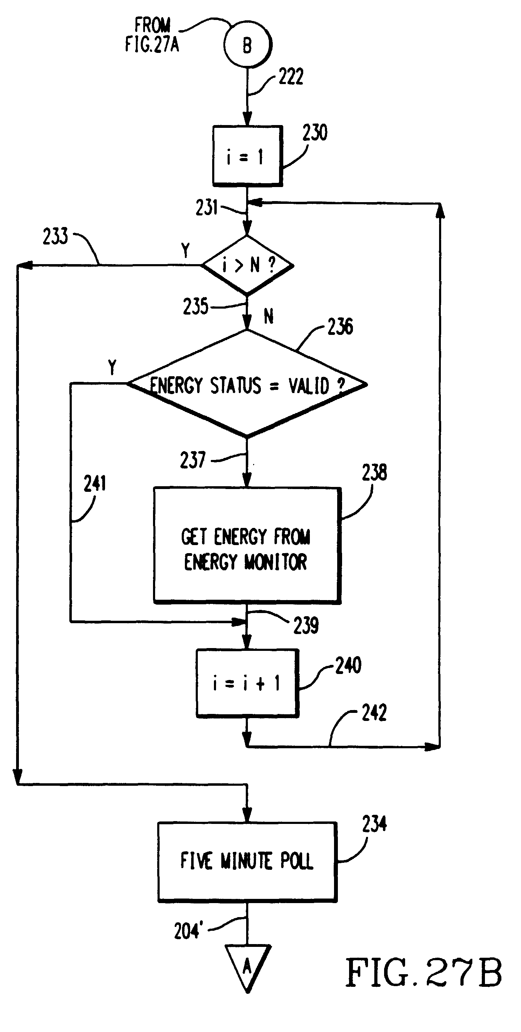

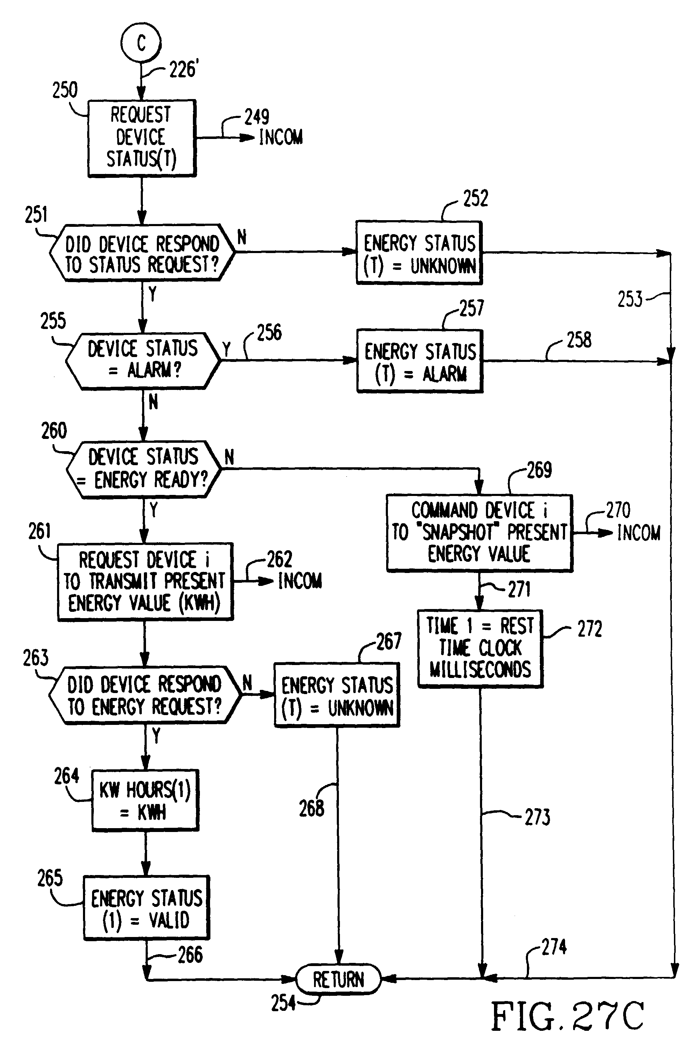

Referring to Figure 25, the energy monitoring system is illustrated with the PC computer station PC sending every five minutes a command to store energy. which is transmitted through the INCOM system to each of the remote stations ST#1, ST#2, .. ST#n. Upon receiving the command (which may be redundant after the first one, but insures that each local station receives the command) at each station the totalized instantaneous energy as shown for one station (station # n) in Figure 25 is locally stored. Accordingly, the multiplexer MUX of station #n receives the signals IA, IB, IC, VA, VB, VC, which are sampled under the control signal of lines 40 and 41, derived from the sampler SMP which is triggered by line 39 from the PTIMER, as explained earlier by reference to the flowchart of Figure 24B according to the sampling rules of Table I and Table II. As explained by reference to Figure 23, the sampled signals are applied by line 32 to the A/D converter ADC, actuated, also, according to the sampler SMP (by lines 40 and 42). The digital signals outputted on line 44 are applied to a multiplier MLT which, under the control signal of line 40, via line 43, generates on line 45 the value IV. The summer SUM passes on line 46 the sampled energy IVs totalized for three phases, and this leads to an accumulated count of total energy Ex at ACCU. This total is constantly updated by each new sampled IVs amount. The latest total is outputted on line 47 which passes through line 48 to storing register STE after being gated by a gate GT. Here come the effects of control by the PC computer station. Each station has been totalizing in one's own register ACCU the latest amount of total energy Ei consumed. When a snapshot command SNP is received from the PC station by line 50 through the INCOM, the gate GT of the addressed station, by line 50, is enabled. Immediately, the latest value Ei is stored by line 48 into register STE. The same is done in each station, simultaneously. Thereafter, by line 51 the PC station reads the amount stored into STE for each station in a sequential manner, for instance in the order 1,2,..n of the stations. Now it is up to the PC station to compare Ei with the last data received Ei-1 and know, for each station, how much energy has been gained within the five minute time interval separating two successive gating commands by line 50 of the particular station. Knowing Ei - E(i-1), the PC station determines the Demand = Ei-E(i-1). Typically, this is handled by software according to the general block diagram of Figure 26 showing the PC station in communication with the energy monitor stations #1, #2, #n. PC-based energy monitoring is performed according to flowcharts of Figures 27A, 27B and 27C.

Referring to Figure 27A, starting at 200, the next step, via line 201 is at 202 to determine whether the TIME interval of, typically 5 minutes, has been initiated. If NO, by line 203 the system goes to A at 104 where it receives by line 204' the result of the routine of Figure 27B. Thereafter, the system proceeds at 205 where background tasks are allowed in the free time left. Then, by line 206 there is a RETURN to line 201 for a new time interval. If there is a YES at 202, by line 207 the system goes to 208 where energy polling from all the stations simultaneously is initiated. This comes by line 209 to step 210 where a command is sent through the INCOM to the local stations to "SNAPSHOT" the present accumulated energy, or "instantaneous value" of energy accumulated at the station. Nevertheless, in order to insure a true and valid command, redundancy is used at this stage by establishing a dead time for a rest of about several milliseconds at 213, which by line 214 is followed by another command for a "SNAPSHOT" at 215 by 216 through the INCOM to the local stations.

Thereafter, takes place the individual polling of all the stations to see how much has been accumulated and to check whether a valid energy value has been called for. This routine starts by line 217, with the number i, of the local station being addressed, being initially made equal to 1 (at 218). Thereafter, the count will increase (at 227) by one until at 220 it reaches n the total number of local stations. If at 220 i=N, by line 221 the system goes to a new series of n stations for polling (line 222 of the routine of Figure 27B). If the system is still during the polling of stations, at line 223 (from step 220) a timer is initialized (at 224) to zero for the station being addressed, and by 225 the system goes to the routine of Figure 27C in order to know the energy accumulated in the local station and, if necessary, to ascertain the validity of the information received, making another call if not valid. Block 226 of the flow chart of Figure 27A is illustrated by the flow chart of Figure 27C described hereinafter. When the energy has been collected for all the stations by line 225' each value of i having been increased by one until at 220 it has reached n, when another command to poll will take place with the new time interval (namely of 5 minutes). If it has (YES on line 221), the system goes to 222 of Figure 27B for station polling. If NO at 220, by line 223 the system goes to 226, a routine which is illustrated by Figure 27C.

Considering step 226 of Figure 27A, Figure 27 illustrates the polling operation for the determination of the energy at each station. Initialization is with i=1 at 230, namely the first addressed station. If before going to the next station (i=i+1 at 240), at 236 is determined whether the energy received is valid. If YES by line 241, the system goes to the next station (adding one to i at 240) until all the stations have been dealt with (n reached at 232). If it is so, by line 233 the system goes to 234 where it is ascertained whether the time interval of 5 minutes has lapsed. If so the system is back to A of Figure 27A. If there is a NO on line 237 of block 236, the system goes to the flow chart routine of Figure 27C in order to seek a valid response. The energy having been received correctly on line 239, like from 241, the system goes to 234.

Considering now Figure 27C (by line 226' from block 226 of Figure 27A) the flowchart goes to 250 where a request for the local station status is transmitted through the INCOM at 251. Then, at 251 the question is raised "whether the addressed station has responded? ". If NOT, this fact is acknowledged at 252 and there is a RETURN by line 253 to 254. If YES at 251, it is determined at 255 whether the status is "ALARM". If YES, at 257 this is acknowledged and there is a RETURN by lines 258 and 253 to 254. If NO alarm has been detected at 255, the determination is at 260 "whether the ENERGY READY status has been obtained". If YES, the station is asked to transmit back the energy (in kilowatthour) by line 262 through the INCOM. If at 263 there is a positive response, at 264 the KWH is known and at 265 it is recognized as valid, whereby via line 266 there is a RETURN at 254. If NO at 263, it is acknowledged at 267 as having an unknown status, and by line 268 there will be a RETURN at 254. Having found a NO at 260, the system at 269, to be sure, makes another request to the station (via line 270). In such case, the time delay is accounted for at 272 with a timer before returning to 254 by line 273.

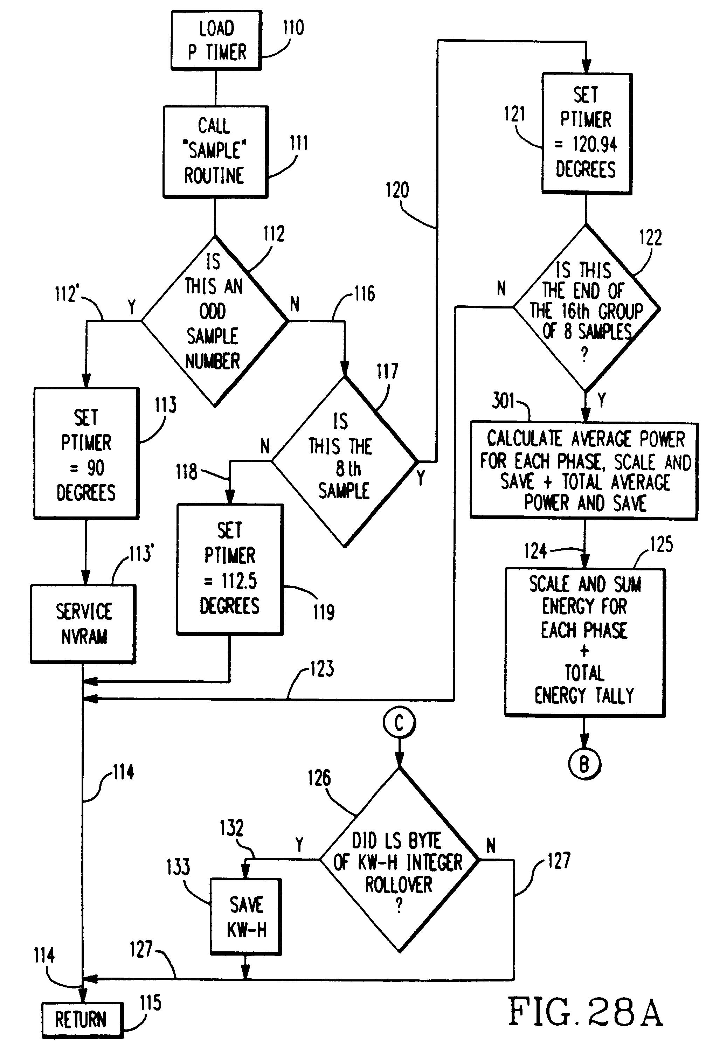

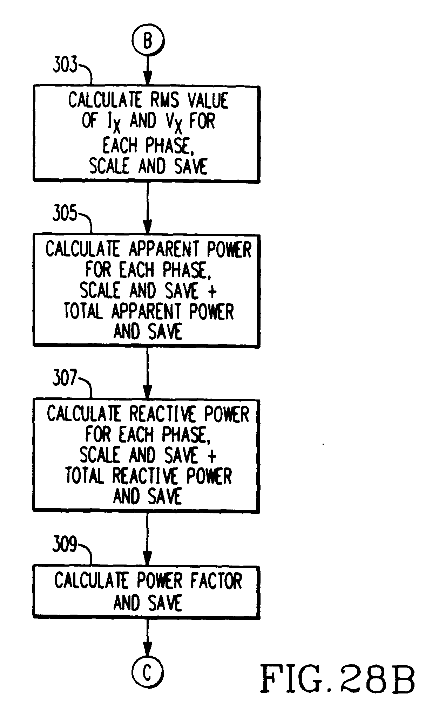

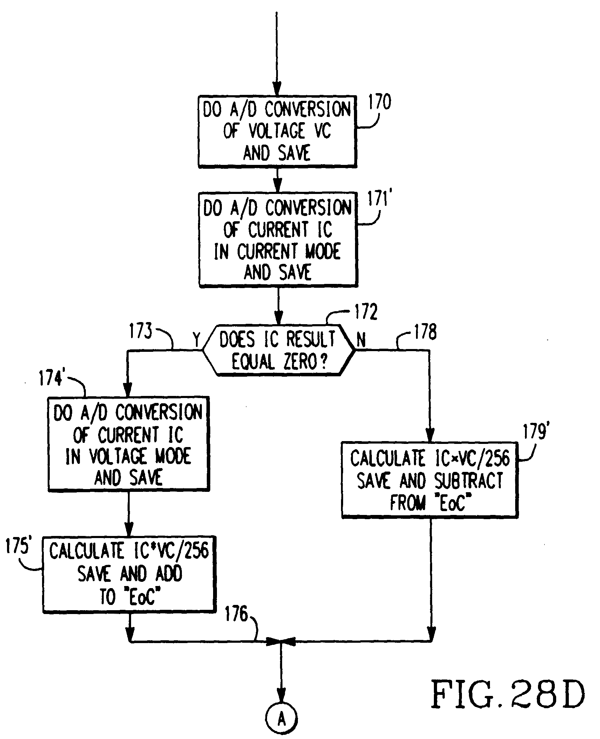

In a further embodiment, the energy monitoring system may be modified to allow for the monitoring of the user's individual current, voltage, and power demands. Turning to Figs. 28A-28E, shown are the flowcharts which illustrate the modification of the energy monitoring system firmware which allows for the monitoring of the user's individual current, voltage, and power consumption. Specifically referring to Figs. 28A and 28B, the flowchart is altered to provide the command to calculate the average power for each phase and to scale and save the resulting values at 301 before the command to scale and sum the energy for each individual phase and provide the energy tally at 125 is issued. Thereafter, the energy calculation demand is followed by the commands to calculate the RMS value of I and V for each phase and to scale and save at 303, the commands to calculate the apparent power for each phase and to scale and save at 305, the commands to calculate the reactive power for each phase and to scale and save at 307, and the commands to calculate and save the power factor at 309.

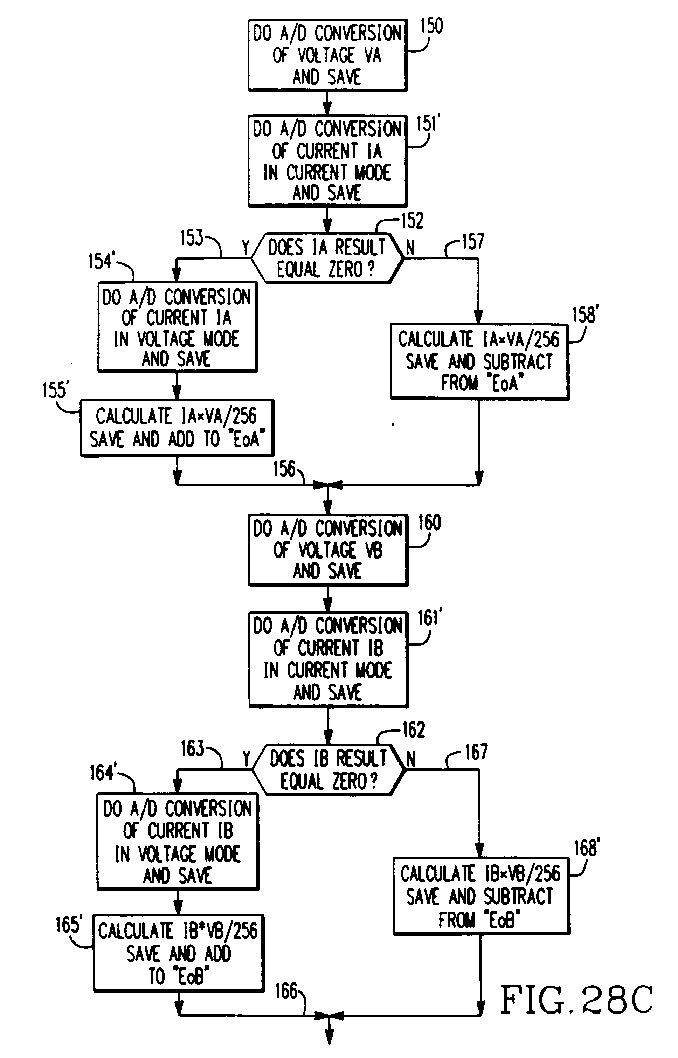

Turning to Figs. 28C-28E, the flowchart for the sample routine is altered to allow for the A/D conversion of the current IA in the current mode to be saved in 151' and for the AID conversion of the current IA in the voltage mode to be saved in 154' should the result of the A/D conversion in 151' be equal to zero. Likewise, for phases B and C, the routine is altered to allow for the A/D conversion of the current IB in the current mode to be saved at 161' and for the A/D conversion of the current IB in the voltage mode to be saved in 164' should the result of the AID conversion in 161' be equal to zero and to allow for the A/D conversion of the current IC in the current mode to be saved at 171' and for the A/D conversion of the current IC in the voltage mode to be saved in 174' should the result of the A/D conversion in 171' be equal to zero.

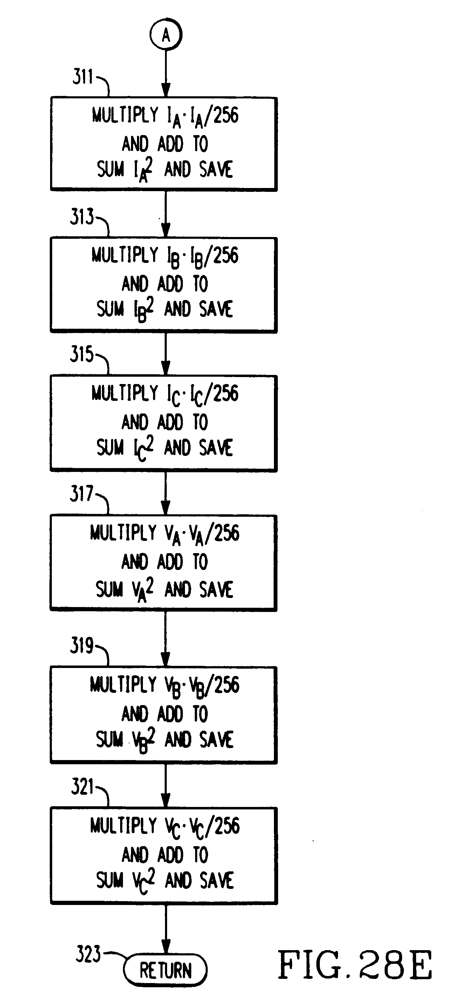

Referring to Fig. 28E, once the values for each phase voltage and current have been converted and stored, the command is issued to square, sum, and save the values for use in the aforementioned RMS and power calculations. Specifically, the command to sum and save IA x IA for each pass is issued in 311 with similar commands being offered for phase currents IB and IC in 313 and 315. The command to sum and save VA x VA for each pass is issued in 317 with similar commands being offered for phase voltages VB and VC in 319 and 321. For scaling purposes, each of the calculated values is divided by the value 256. The common RETURN is then issued at 323. As it appears from the last steps of the flowcharts, after the A/D conversion a sample is derived of VA and IA for phase A, of VB and IB for phase B and of VC and IC for phase C from which samples the power values are calculated by phase, to be totalized for the three phases.

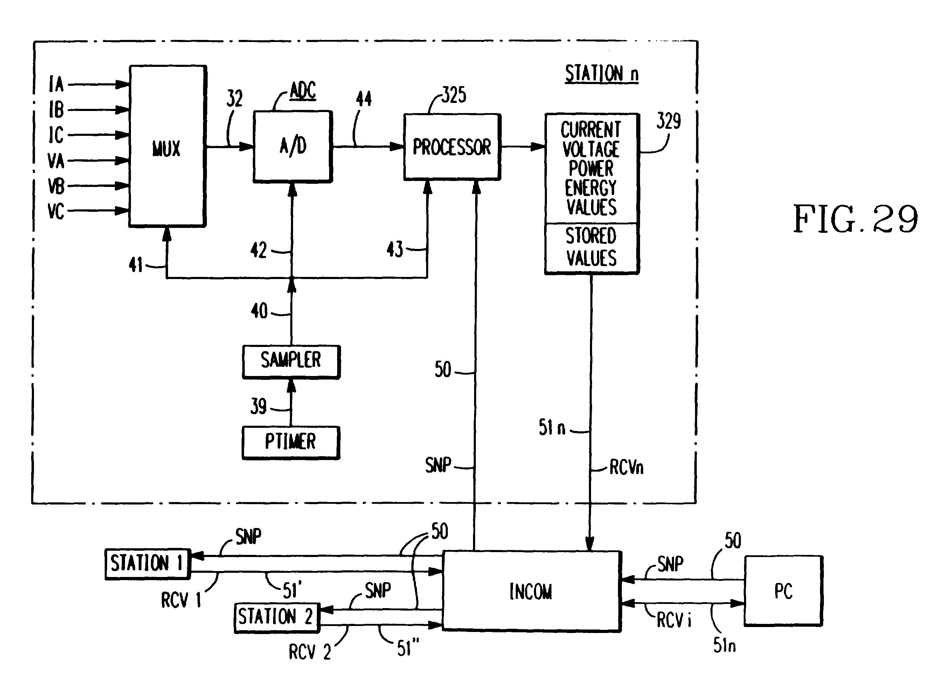

As with the calculated energy values, the power, current, and voltage monitoring is done by the backpack unit at all stations for the various local users, and the results are ready at any time to be withdrawn by the PC computer station from all stations over the aforementioned communication network. This may be used at the PC computer station, or any other chosen station, to monitor the overall electrical demands. As explained previously and now in reference to Fig. 29, the sampled signals are applied by line 32 to the A/D converter ADC actuated according to the sampler by lines 40 and 42. The digital signals outputted on line 44 are applied to the processor 325 wherein the energy, power, rms voltage, and rms current values are derived. These values are constantly updated by each new sampled amount, wherein a snapshot command via line 50 will result in the values being stored. These stored values are accessible to the network on software command from line 50 to be outputted on line 51n. As previously described, the central computer station has the capability to individually poll the stations to gather the information stored in the registers.

## Claims

1. An electrical monitoring system for use on an AC line, comprising a circuit breaker installed on said AC line, characterised in that a backpack unit (BPU) is mounted on said circuit breaker (CB) and has an opening through which said AC line is passed, said backpack unit (BPU) further has mounted therein transducer means (CT, R5) cooperating with said AC line for deriving analog signals representative of AC line current and voltage, analog to digital means (in PCBB) for converting said analog signals to digital signals, and processing means for computing electrical measurements from said digital signals;

   a remote monitoring device (PC) for retrieving said computed electrical measurements; and

   bi-directional digital communication means (78) linking said backpack unit (BPU) and said remote monitoring device (PC) for establishing a data highway therebetween.

2. A system according to claim 1, characterised in that the transducer means comprises a current transducer (CT) inductively coupled with the AC line and a voltage metering device (R4) connected to said AC line.

3. A system according to claim 2, characterised in that said system further comprises a PC board (PCBA) mounted in the backpack unit having an opening (OA) around which is mounted the current transducer (CT) and in that the AC line is passed through said opening (OA) and through said current transducer (CT).

4. A system according to claim 3, characterised in that the analog to digital means and the processing means are integrated in a CMOS monolithic circuit (SP).

5. A system according to claim 4, characterised in that said system further comprises a second PC board (PCCB) mounted in the backpack unit (BPU) on which the CMOS monolithic circuit (SP) is mounted.

6. A system according to claim 3, characterised in that the circuit breaker (CB) has a female terminal (TA) into which the AC line is inserted and in that the backpack unit (BPU) has a stab (LG) cooperating with said female terminal (TA) for mounting said backpack unit (BPU) on said circuit breaker, said stab (LG) providing the connection between said AC line and the voltage metering device.

7. A system according to claim 6, characterised in that at least one of the computed electrical measurements is a value representative of an RMS current value associated with the AC line.

8. A system according to claim 6, characterised in that at least one of the computed electrical measurements is a value representative of an RMS voltage value associated with the AC line.

9. A system according to claim 6, characterised in that at least one of the computed electrical measurements is a set of values representative of power value associated with the AC line.

10. A system according to claim 6, characterised in that at least one of the computed electrical measurements is a value representative of an energy value associated with the AC line.

11. An electrical monitoring system for use behind a collective electrical meter having a plurality of AC lines associated therewith, said system comprising a plurality of circuit breakers (CB) wherein each one of said AC lines has installed thereon one of said plurality of circuit breakers, characterised in that a plurality of backpack units (BPU) is individually mounted on each of said circuit breakers (CB), each of said backpack units (BPU) having an opening (OA, OB, OC respectively) through which said AC line is passed so that a backpack unit (BPU) mounts to a circuit breaker (CB) and an AC line passed through the backpack unit (BPU) and connects to the circuit breaker (CB), and in that each of said backpack units (BPU) further has transducer means (TC) cooperating with said AC line for deriving analog signals representative of AC line current and voltage (CT, R4, R5, R6), analog to digital means (in PCCB) for converting said analog signals to digital signals, processing means for computing electrical measurements from said digital signals and storage means for saving said electrical measurements;

a remote monitoring device (PC) for retrieving said electrical measurements from each of said plurality of backpack units (BPU); and

bi-directional digital communication means (78) linking said remote monitoring device (PC) to each of said plurality of backpack units (BPU) for establishing a data highway therebetween.

12. A system according to claim 11, characterised in that the bi-directional communication means (78) is used at regular successive intervals by the remote monitoring device (PC) to initially and simultaneously address and command each of the plurality of backpack units (BPU) to store the electrical measurements whereby said remote monitoring device (PC) may address and poll each of said plurality of backpack units (BPU) individually to retrieve the stored electrical measurements.

13. A system according to claim 12, characterised in that the transducer means comprise a current transducer (CT) inductively coupled with the AC line and a voltage metering device (R4, R5, R6) connected to said AC line.

14. A system according to claim 13, characterised in that each of the plurality of backpack units (BPU) further has a PC board mounted therein having an opening around which is mounted the current transducer (CT) and in that the AC line passes through said opening and through said current transducer (CT).

15. A system according to claim 14, characterised in that analog to digital means and the processing means are integrated in a CMOS monolithic circuit (SP).

16. A system according to claim 15, characterised in that each of the plurality of backpack units (BPU) further has a second PC board (PCCB) on which the CMOS monolithic circuit (SP) is mounted.

17. A system according to claim 14, characterised in that each of the plurality of circuit breakers has a female terminal (TA, TB, TC respectively) into which the AC line is connected and in that each of the backpack units (BPU) has a stab (LG) cooperating with said female terminal for mounting said backpack unit (BPU) on said circuit breaker (CB) and in that said stab (LG) provides the connection between said AC line and the voltage metering device.

18. A system according to claim 17, characterised in that at least one of the electrical measurements is a value representative of an RMS current value associated with the individual AC line to which the backpack is connected.

19. A system according to claim 17, characterised in that at least one of the electrical measurements is a value representative of an RMS voltage value associated with the individual AC line to which the backpack unit is connected.

20. A system according to claim 17, characterised in that at least one of the electrical measurements is a set of values representative of power values associated with the individual AC line to which the backpack unit is connected.

21. A system according to claim 17, characterised in that at least one of the electrical measurements is a value representative of an energy consumption associated with the individual AC line to which the backpack unit is connected.

**Patentansprüche**

1. Elektrisches Überwachungssystem zur Verwendung auf einer Wechselstromleitung, versehen mit einem auf der Wechselstromleitung installierten Schutzschalter, dadurch gekennzeichnet, daß eine Aufsatzeinheit (BPU) auf dem Schutzschalter (CB) montiert ist und eine Öffnung aufweist, durch welche die Wechselstromleitung geführt ist, wobei in der Aufsatzeinheit (BPU) ferner eine Wandler-Einrichtung (CT, R5), die mit der Wechselstromleitung zusammenwirkt, um Analogsignale zu gewinnen, welche den Strom und die Spannung auf der Wechselstromleitung wiedergeben, eine Analog-nach-Digital-Wandler-Einrichtung (in PCBB) zum Umwandeln der Analogsignale in Digitalsignale sowie eine Verarbeitungseinrichtung zum Berechnen elektrischer Messungen aus den Digitalsignalen montiert sind;

einer Fernüberwachungs-Einrichtung (PC) zum Rückgewinnen der berechneten elektronischen Messungen; und
einer bi-direktionalen digitalen Kommunikationseinrichtung (78), welche die Aufsatzeinheit (BPU) und die Fernüberwachungs-Einrichtung (PC) verbindet, um zwischen diesen eine Datenleitung einzurichten.

**2.** System gemäß Anspruch 1, dadurch gekennzeichnet, daß die Wandler-Einrichtung einen Strommeßwert-Umformer (CT), der induktiv mit der Wechselstromleitung gekoppelt ist, sowie eine Spannungserfassungs-Einrichtung (R4), die mit der Wechselstromleitung verbunden ist, umfaßt.

**3.** System gemäß Anspruch 2, dadurch gekennzeichnet, daß das System ferner eine Leiterplatte (PCBA), die in der Aufsatzeinheit montiert ist und eine Öffnung (OA) aufweist, um welche der Strommeßwert-Umformer (CT) montiert ist, und die Wechselstromleitung durch die Öffnung (OA) und den Strommeßwert-Umformer (CT) geführt ist.

**4.** System gemäß Anspruch 3, dadurch gekennzeichnet, daß die Analog-nach-Digital-Wandlereinrichtung und die Verarbeitungseinrichtung in einem monolithischen CMOS-Schaltkreis (SP) integriert sind.

**5.** System gemäß Anspruch 4, dadurch gekennzeichnet, daß das System ferner eine zweite Leiterplatte (PCCB) aufweist, die in der Aufsatzeinheit (BPU) montiert ist und auf welcher der monolithische CMOS-Schaltkreis (SP) montiert ist.

**6.** System gemäß Anspruch 3, dadurch gekennzeichnet, daß der Schutzschalter (CB) einen Buchsenanschluß (TA) aufweist, in welchen die Wechselstromleitung eingeführt ist, und die Aufsatzeinheit (BPU) einen Stift (LG) aufweist, der mit dem Buchsenanschluß (TA) zusammenwirkt, um die Aufsatzeinheit (BPU) auf dem Schutzschalter zu montieren, wobei der Stift (LG) für die Verbindung zwischen der Wechselstromleitung und der Spannungserfassungs-Einrichtung sorgt.

**7.** System gemäß Anspruch 6, dadurch gekennzeichnet, daß mindestens eine der berechneten elektrischen Messungen ein Wert ist, der einen mit der Wechselstromleitung verbundenen Effektivstromwert wiedergibt.

**8.** System gemäß Anspruch 6, dadurch gekennzeichnet, daß mindestens eine der berechneten elektrischen Messungen ein Wert ist, der einen mit der Wechselstromleitung verbundenen Effektivspannungswert wiedergibt.

**9.** System gemäß Anspruch 6, dadurch gekennzeichnet, daß mindestens eine der berechneten elektrischen Messungen ein Wertesatz ist, der den mit der Wechselstromleitung verbundenen Leistungswert wiedergibt.

**10.** System gemäß Anspruch 6, dadurch gekennzeichnet, daß mindestens eine der berechneten elektrischen Messungen ein Wert ist, der einen mit der Wechselstromleitung verbundenen Energiewert wiedergibt.

**11.** Elektrisches Überwachungssystem zur Verwendung hinter einem Sammelstromzähler mit einer Mehrzahl von damit verbundenen Wechselstromleitungen, wobei das System eine Mehrzahl von Schutzschaltern (CB) aufweist und wobei auf jeder Wechselstromleitung einer aus dieser Mehrzahl von Schutzschaltern montiert ist, dadurch gekennzeichnet, daß eine Mehrzahl von Aufsatzeinheiten (BPU) individuell auf jedem der Schutzschalter (CB) montiert ist, jede der Aufsatzeinheiten (BPU) mit einer Öffnung (OA, OB bzw. OC) versehen ist, durch welche die Wechselstromleitung geführt ist, so daß eine Aufsatzeinheit (BPU) mit einem Schutzschalter (CB) und einer durch die Aufsatzeinheit (BPU) geführten Wechselstromleitung montiert ist und mit dem Schutzschalter (CB) verbunden ist, und jede der Aufsatzeinheiten (BPU) ferner mit einer Wandlereinrichtung (TC), die mit der Wechselstromleitung zusammenwirkt, um Analogsignale zu gewinnen, die Strom und Spannung (CT, R4, R5, R6) der Wechselstromleitung wiedergeben, einer Analog-nach-Digital-Wandler-Einrichtung (in PCCB) zum Umwandeln der Analogsignale in Digitalsignale, einer Verarbeitungseinrichtung zum Berechnen von elektrischen Messungen aus den Digitalsignalen sowie einer Speichereinrichtung zum Speichern der elektrischen Messungen versehen ist;

wobei das System ferner eine Fernüberwachungs-Einrichtung (PC) zum Wiedergewinnen der elektrischen Messungen aus jeder Aufsatzeinheit (BPU) und

eine bi-direktionale digitale Kommunikationseinrichtung (78) aufweist, welche die Fernüberwachungseinrichtung (PC) mit jeder Aufsatzeinheit (BPU) verbindet, um eine Datenleitung dazwischen aufzubauen.

**12.** System gemäß Anspruch 11, dadurch gekennzeichnet, daß die bi-direktionale Kommunikationseinrichtung (78) in regelmäßigen aufeinanderfolgenden Intervallen von der Fernüberwachungseinrichtung (PC) verwendet wird, um anfänglich und gleichzeitig jede der Aufsatzeinheiten (BPU) zu adressieren und zu befehligen, um die elektrischen Messungen zu speichern, wobei die Fernüberwachungseinrichtung (PC) jede der Aufsatzeinheiten (BPU) individuell adressieren und abfragen kann, um die gespeicherten elektrischen Messungen wiederzugewinnen.

**13.** System gemäß Anspruch 12, dadurch gekennzeichnet, daß die Wandlereinrichtung einen Strommeßwert-Umformer (CT), der induktiv mit der Wechselstromleitung (AC) gekoppelt ist, sowie eine Spannungserfassungs-Einrichtung (R4, R5, R6) aufweist, die mit der Wechselstromleitung verbunden ist.

14. System gemäß Anspruch 13, dadurch gekennzeichnet, daß jede der Aufsatzeinheiten (BPU) ferner eine Leiterplatte aufweist, die in der Aufsatzeinheit montiert ist und eine Öffnung aufweist, um welche der Strommeßwert-Umformer (CT) montiert ist, und die Wechselstromleitung durch die Öffnung und den Strommeßwert-Umformer (CT) geführt ist.

15. System gemäß Anspruch 14, dadurch gekennzeichnet, daß die Analog-nach-Digital-Wandler-Einrichtung und die Verarbeitungseinrichtung in einem monolithischen CMOS-Schaltkreis (SP) integriert sind.

16. System gemäß Anspruch 15, dadurch gekennzeichnet, daß jede Aufsatzeinheit (BPU) ferner eine zweite Leiterplatte (PCCB) aufweist, auf welcher der monolithische CMOS-Schaltkreis (SP) montiert ist.

17. System gemäß Anspruch 14, dadurch gekennzeichnet, daß jeder Schutzschalter einen Buchsenanschluß (TA, TB bzw. TC) aufweist, in welchen die Wechselstromleitung eingesteckt ist, und jede Aufsatzeinheit (BPU) einen Stift (LG) aufweist, welcher mit dem Buchsenanschluß zwecks Montage der Aufsatzeinheit (BPU) auf dem Schutzschalter (CB) zusammenwirkt und für die Verbindung zwischen der Wechselstromleitung und der Spannungserfassungs-Einrichtung sorgt.

18. System gemäß Anspruch 17, dadurch gekennzeichnet, daß mindestens eine der elektrischen Messungen ein Wert ist, der einen Effektivstromwert wiedergibt, der mit der individuellen Wechselstromleitung verbunden ist, mit welcher die Aufsatzeinheit verbunden ist.

19. System gemäß Anspruch 17, dadurch gekennzeichnet, daß mindestens eine der elektrischen Messungen ein Wert ist, der einen Effektivspannungswert wiedergibt, der mit der individuellen Wechselstromleitung verbunden ist, mit welcher die Aufsatzeinheit verbunden ist.

20. System gemäß Anspruch 17, dadurch gekennzeichnet, daß mindestens eine der elektrischen Messungen ein Wertesatz ist, der die Leistungswerte wiedergibt, die mit der individuellen Wechselstromleitung verbunden sind, mit welcher die Aufsatzeinheit verbunden ist.

21. System gemäß Anspruch 17, dadurch gekennzeichnet, daß mindestens eine der elektrischen Messungen ein Wert ist, der den Energieverbrauch wiedergibt, der mit der individuellen Wechselstromleitung verbunden ist, mit welcher die Aufsatzeinheit verbunden ist.

**Revendications**

1. Un système de contrôle électrique à utiliser sur une ligne en courant alternatif, comprenant un disjoncteur installé sur ladite ligne en courant alternatif, caractérisé par le fait

   qu'une unité dorsale (BPU) est montée sur ledit disjoncteur (CB) et dispose d'une ouverture par laquelle ladite ligne en courant alternatif passe, au sein de ladite unité dorsale (BPU) un transducteur (CT, R5) est en outre monté et travaille avec le concours de ladite ligne en courant alternatif pour faire dériver les signaux analogiques représentatifs du courant et de la tension de la ligne en courant alternatif, les moyens permettant le passage de l'analogique au numérique (sur PCBB) pour la conversion desdits signaux analogiques en signaux numériques, et les moyens de traitement pour le calcul des mesures électriques provenant desdits signaux numériques;
   un appareil de contrôle à distance (PC) pour récupérer lesdites mesures électriques calculées; et
   des moyens de communication numériques bi-directionnels (78) mettant en liaison ladite unité dorsale (BPU) et ledit appareil de contrôle à distance (PC) pour créer une autoroute de l'information entre les deux.

2. Un système selon la revendication 1, caractérisé par le fait

   que les ressources du transducteur se composent d'un transducteur de courant (CT) à couplage inductif à la ligne en courant alternatif et d'un dispositif de mesure de tension (R4) connecté à ladite ligne en courant alternatif.

3. Un système selon la revendication 2, caractérisé par le fait

   que ledit système comprend en outre une plaquette de circuit imprimé (PCBA) montée à l'intérieur de l'unité dorsale disposant d'une ouverture (OA) autour de laquelle le transducteur de courant (CT) est monté et par le fait que la ligne en courant alternatif passe par ladite ouverture (OA) et ledit transducteur de courant (CT).

**4.** Un système selon la revendication 3, caractérisé par le fait

que les moyens permettant le passage de l'analogique au numérique et les moyens de traitement sont intégrés dans un circuit monolithique CMOS (SP).

**5.** Un système selon la revendication 4, caractérisé par le fait

que ledit système comprend en outre une seconde plaquette de circuit imprimé (PCCB) montée à l'intérieur de l'unité dorsale (BPU) sur laquelle le circuit monolithique CMOS (SP) est monté.

**6.** Un système selon la revendication 3, caractérisé par le fait

que le disjoncteur (CB) est pourvu d'une connexion femelle (TA) dans laquelle la ligne en courant alternatif est insérée et par le fait que l'unité dorsale (BPU) est pourvue d'une tige (LG) coopérant avec ladite connexion femelle (TA) pour le montage de ladite unité dorsale (BPU) sur ledit disjoncteur, ladite tige (LG) permettant la liaison entre ladite ligne en courant alternatif et le dispositif de mesure de tension.

**7.** Un système selon la revendication 6, caractérisé par le fait

qu'au moins une des mesures électriques calculées est une valeur représentative d'une valeur de courant RMS associée à la ligne en courant alternatif.

**8.** Un système selon la revendication 6, caractérisé par le fait

qu'au moins une des mesures électriques calculées est une valeur représentative d'une valeur de tension RMS associée à la ligne en courant alternatif.

**9.** Un système selon la revendication 6, caractérisé par le fait

qu'au moins une des mesures électriques calculées est un ensemble de valeurs représentatives de la valeur de puissance associée à la ligne en courant alternatif.

**10.** Un système selon la revendication 6, caractérisé par le fait

qu'au moins une des mesures électriques calculées est une valeur représentative d'une valeur énergétique associée à la ligne en courant alternatif.

**11.** Un système de contrôle électrique à utiliser derrière un compteur électrique collectif ayant plusieurs lignes en courant alternatif qui y sont associées, ledit système comprenant plusieurs disjoncteurs (CB) dont chacune desdites lignes en courant alternatif est pourvue, caractérisé par le fait

que plusieurs unités dorsales (BPU) sont montées individuellement sur chacun desdits disjoncteurs (CB), chacune desdites unités dorsales (BPU) étant pourvue d'une ouverture (respectivement, OA, OB, OC) par laquelle ladite ligne en courant alternatif passe de manière à ce qu'une unité dorsale (BPU) monte vers un disjoncteur (CB) et qu'une ligne en courant alternatif passe par l'unité dorsale (BPU) et soit connectée au disjoncteur (CB), et par le fait que chacune des unités dorsales (BPU) est en outre dotée d'un circuit transducteur (TC) coopérant avec ladite ligne en courant alternatif pour faire dériver les signaux analogiques représentatifs du courant et de la tension de la ligne en courant alternatif (CT, R4, R5, R6), les moyens analogiques vers les moyens numériques (en PCCB) pour la conversion desdits signaux analogiques en signaux numériques, les moyens de traitement pour le calcul des mesures électriques provenant desdits signaux numériques et les moyens de stockage pour sauvegarder lesdites mesures électriques;
un appareil de contrôle à distance (PC) pour récupérer les mesures électriques de chacune desdites multiples unités dorsales (BPU); et
les moyens de communication numériques bidirectionnels (78) mettant en liaison ledit appareil de contrôle à distance et chacune desdites multiples unités dorsales (BPU) pour créer une autoroute de l'information entre les deux.

**12.** Un système selon la revendication 11, caractérisé par le fait

que le moyen de communication bi-directionnel (78) est utilisé à intervalles successifs réguliers par l'appareil de contrôle à distance (PC) pour adresser et envoyer des instructions au commencement et simultanément à chacune des multiples unités dorsales (BPU) pour qu'elles stockent les mesures électriques par lesquelles ledit appareil de contrôle à distance (PC) peut individuellement accéder à et interroger chacune desdites multiples unités dorsales pour récupérer les mesures électriques stockées.

**13.** Un système selon la revendication 12, caractérisé par le fait

que les ressources du transducteur comprennent un transducteur de courant (CT) à couplage inductif à la ligne en courant alternatif et un dispositif de mesure de tension (R4, R5, R6) connecté à ladite ligne en courant alternatif.

**14.** Un système selon la revendication 13, caractérisé par le fait

que chacune des multiples unités dorsales (BPU) comprend en outre une plaquette de circuit imprimé montée à l'intérieur des unités dorsales disposant d'une ouverture autour de laquelle le transducteur de courant est monté (CT) et par le fait que la ligne en courant alternatif passe par ladite ouverture et ledit transducteur de courant (CT).

**15.** Un système selon la revendication 14, caractérisé par le fait

que les moyens permettant le passage de l'analogique au numérique et les moyens de traitement sont intégrés dans un circuit monolithique CMOS (SP).

**16.** Un système selon la revendication 15, caractérisé par le fait

que chacune des multiples unités dorsales (BPU) comprend en outre une seconde plaquette de circuit imprimé (PCCB) sur laquelle le circuit monolithique CMOS (SP) est monté.

**17.** Un système selon la revendication 14, caractérisé par le fait

que chacun des multiples disjoncteurs est pourvu d'une connexion femelle (respectivement, TA, TB, TC) à laquelle la ligne en courant alternatif est connectée et par le fait que chacune des unités dorsales (BPU) est pourvue d'une tige (LG) coopérant avec ladite connexion femelle pour le montage de ladite unité dorsale (BPU) sur ledit disjoncteur (CB) et par le fait que ladite tige (LG) permet la liaison entre ladite ligne en courant alternatif et le dispositif de mesure de tension.

**18.** Un système selon la revendication 17, caractérisé par le fait

qu'au moins une des mesures électriques est une valeur représentative d'une valeur de courant RMS associée à la ligne individuelle en courant alternatif à laquelle l'unité dorsale est connectée.

**19.** Un système selon la revendication 17, caractérisé par le fait

qu'au moins une des mesures électriques est une valeur représentative d'une valeur de tension RMS associée à ligne individuelle en courant alternatif à laquelle l'unité dorsale est connectée.

**20.** Un système selon la revendication 17, caractérisé par le fait

qu'au moins une des mesures électriques est un ensemble de valeurs représentatives des valeurs de puissance associées à la ligne individuelle en courant alternatif à laquelle l'unité dorsale est connectée.

**21.** Un système selon la revendication 17, caractérisé par le fait

qu'au moins une des mesures électriques est une valeur représentative de la consommation d'énergie associée à la ligne individuelle en courant alternatif à laquelle l'unité dorsale est connectée.

INDIVIDUAL
BILLING

PC ← INCOM

LOAD

INCOM
CABLE

J1 BPU

CB

PCBB

J4 PCBA

LOAD

INCOM
CABLE

J1 BPU

CB

PCBB

J4 PCBA

LOAD

INCOM
CABLE

J1 BPU

CB

PCBB

J4 PCBA

PNB

MAIN
AC
LINE

METER

## FIG. 1

FIG.2A

FIG.2B

FIG.3A

FIG.3C

FIG.3B

FIG.3D

FIG. 4 A

INCOM

BPU

J1

LOAD CABLE

SCW

LG

42

30

R4

38

38'

PCBA

J4

PCBB

CB

SCW

40

40'

40"

AC LINE

EP 0 528 634 B1

FIG. 4B

5C

5B

ADD

OP

OA OB OC

LG

BPU

FIG. 5A

LG LG

CV PCBA

BX PCBB

FIG. 5B

FIG.5C

FIG.6A

FIG.6B

FIG. 7

FIG. 8 A

FIG.8B

FIG. 9

FIG. 10 A

FIG. 10 B

FIG.11

FIG.12

EP 0 528 634 B1

FIG.13

FIG.14

FIG.14A

EP 0 528 634 B1

PCBA          PCBB

IA
IB
IC
VAN          MULTIPLEXER
VBN
VCN

INCOM

A/D
CONVERTER

MCU

RAM

EPROM

FIG.15

FIG.16

ELECTRICAL COMPANY MAIN LINE

METER

LOCAL USERS

AC LINE

CB — BPU — J1 — LOCAL USE #1

CB — BPU — J1 — LOCAL USE #2 ~78

CB — BPU — J1 — LOCAL USE #3

CB — BPU — J1 — LOCAL USE #n ~78

78

INCOM

PC

COLLECTIVE ENERGY MONITORING

FIG.16A

EP 0 528 634 B1

FIG.17

FIG.18A

EP 0 528 634 B1

FIG.18B

EP 0 528 634 B1

FIG. 19A

EP 0 528 634 B1

EP 0 528 634 B1

FIG.19B

FIG.19C

EP 0 528 634 B1

J3

1
2  VAN
3  VBN
4  VCN
5  IA
6  IB
7  IC
8

P59  P61  P63  P49  P51  P53

# FIG.19D

A

R5
R6
VR1
P5
P7
P9
P11
CR11  CR9
CR12  CR10
P10
CR2
C1
P15
R3
Q1
CR1
P47  B+
P57  VDD
VA

# FIG.19E

FIG. 20

16 OCTAVES $0_0 - 0_{15}$

SURE 16R.PIC

FIG.21A

SURE 64R.PIC

FIG.21B

FIG.22A

FIG.22B

FIG.22C

FIG.22D

FIG.22E

$$GAIN = \frac{R1 + R2}{R1}$$

SP

FIG.22F

CURRENT MODE

VOLTAGE MODE

FIG.22G

FIG. 23

POWER
"ON"
RESET — 100

↓

INITIALIZATION — 101

↓

START — 102 ← — 108

↓

FABRICATE
"IMPACC"
BUFFERS — 103

↓

CALL
INCOM — 104

↓

UPDATE
NVRAM — 105

DO
"DEADMAN" — 107

DO
ROM
CHECK — 106

# FIG. 24A

52

LOAD
P TIMER — 110

CALL
"SAMPLE"
ROUTINE — 111

112
IS
THIS AN
ODD
SAMPLE
NUMBER

112' — Y

N — 116

SET
PTIMER
= 90
DEGREES — 113

113' — SERVICE
NVRAM

117
IS THIS THE
8th
SAMPLE

N — 118

SET
PTIMER
= 112.5
DEGREES — 119

Y

120

SET
PTIMER
= 120.94
DEGREES — 121

122
IS
THIS
THE END
OF THE
16th GROUP
OF 8 SAMPLES
?

N

124 — Y — 125

SCALE
AND SUM
ENERGY
FOR
EACH PHASE
+
TOTAL
ENERGY TALLY

123

114

126
DID
LS BYTE
OF KW-H
INTEGER
ROLLOVER
?

132 — Y

133 — SAVE
KW-H

N — 127

114 — 127

RETURN — 115

FIG. 24B

DO A/D CONVERSION
OF VOLTAGE VA
AND SAVE — 150

DO A/D CONVERSION
OF CURRENT IA
IN VOLTAGE MODE — 151

153 — Y / DOES IA RESULT \ N — 157
        \ EQUAL ZERO ? / — 152

154 — DO A/D CONVERSION
      OF CURRENT IA
      IN CURRENT MODE

SUBTRACT
IA×VA/256
FROM "EoA" — 158

155 — ADD
      IA×VA/256
      TO "EoA"

DO A/D OF IA
IN CURRENT MODE — 159

156

DO A/D CONVERSION
OF VOLTAGE VB
AND SAVE — 160

DO A/D CONVERSION
OF CURRENT IB
IN VOLTAGE MODE — 161

163 — Y / DOES IB RESULT \ N — 167
        \ EQUAL ZERO ? / — 162

164 — DO A/D CONVERSION
      OF CURRENT IB
      IN CURRENT MODE

SUBTRACT
IB×VB/256
FROM "EoB" — 168

165 — ADD
      IB×VB/256
      TO "EoB"

DO A/D OF IB
IN CURRENT MODE — 169

166

FIG. 24C

| | |
|---|---|
| DO A/D CONVERSION OF VOLTAGE VC AND SAVE | 170 |

| | |
|---|---|
| DO A/D CONVERSION OF CURRENT IC IN VOLTAGE MODE | 171 |

172

173 Y / DOES IC RESULT EQUAL ZERO? \ N 178

174
| | |
|---|---|
| DO A/D CONVERSION OF CURRENT IC IN CURRENT MODE | |

179
| | |
|---|---|
| SUBTRACT IC×VC/256 FROM "EoC" | |

175
| | |
|---|---|
| ADD IC*VC/256 TO "EoC" | |

180
| | |
|---|---|
| DO A/D OF IC IN CURRENT MODE | |

176

177 ( RETURN )

## FIG.24D

PC
| | |
|---|---|
| PERSONEL COMPUTER | |

EM1
| ENERGY MONITOR #1 |
|---|

EM2

| ENERGY MONITOR #2 |
|---|

. . .

EMn
| ENERGY MONITOR #n |
|---|

## FIG.26

55

FIG.25

FIG.27A

FIG. 27B

FIG.27C

FIG.28A

(B)

303 — CALCULATE RMS VALUE
OF $I_X$ AND $V_X$ FOR
EACH PHASE,
SCALE AND SAVE

305 — CALCULATE APPARENT POWER
FOR EACH PHASE,
SCALE AND SAVE +
TOTAL APPARENT POWER
AND SAVE

307 — CALCULATE REACTIVE POWER
FOR EACH PHASE,
SCALE AND SAVE +
TOTAL REACTIVE POWER
AND SAVE

309 — CALCULATE POWER FACTOR
AND SAVE

(C)

FIG. 28B

DO A/D CONVERSION
OF VOLTAGE VA
AND SAVE — 150

DO A/D CONVERSION
OF CURRENT IA
IN CURRENT MODE
AND SAVE — 151'

152 — DOES IA RESULT EQUAL ZERO?

Y — 153

N — 157

DO A/D CONVERSION
OF CURRENT IA
IN VOLTAGE MODE
AND SAVE — 154'

CALCULATE IA×VA/256
SAVE AND SUBTRACT
FROM "EoA" — 158'

CALCULATE IA×VA/256
SAVE AND ADD TO "EoA" — 155'

156

DO A/D CONVERSION
OF VOLTAGE VB
AND SAVE — 160

DO A/D CONVERSION
OF CURRENT IB
IN CURRENT MODE
AND SAVE — 161'

162 — DOES IB RESULT EQUAL ZERO?

Y — 163

N — 167

DO A/D CONVERSION
OF CURRENT IB
IN VOLTAGE MODE
AND SAVE — 164'

CALCULATE IB×VB/256
SAVE AND SUBTRACT
FROM "EoB" — 168'

CALCULATE IB*VB/256
SAVE AND ADD
TO "EoB" — 165'

166

FIG.28C

FIG.28D

311 ─ MULTIPLY $I_A \cdot I_A / 256$
AND ADD TO
SUM $I_A^2$ AND SAVE

313 ─ MULTIPLY $I_B \cdot I_B / 256$
AND ADD TO
SUM $I_B^2$ AND SAVE

315 ─ MULTIPLY $I_C \cdot I_C / 256$
AND ADD TO
SUM $I_C^2$ AND SAVE

317 ─ MULTIPLY $V_A \cdot V_A / 256$
AND ADD TO
SUM $V_A^2$ AND SAVE

319 ─ MULTIPLY $V_B \cdot V_B / 256$
AND ADD TO
SUM $V_B^2$ AND SAVE

321 ─ MULTIPLY $V_C \cdot V_C / 256$
AND ADD TO
SUM $V_C^2$ AND SAVE

323 ─ RETURN

FIG. 28E

FIG.29

EP 0 528 634 B1